# EUROPEAN PATENT APPLICATION

(11) **EP 4 507 472 A1**
(43) Date of publication of application: **12.02.2025**
(21) Application number: 24193203.7
(22) Date of filing: 06.08.2024
(51) Int. Cl.: H10B 43/27, H10B 43/40

(54) **SEMICONDUCTOR DEVICE AND DATA STORAGE SYSTEM INCLUDING THE SAME**

(30) Priority: 11.08.2023 KR 20230105422
(71) Applicant: Samsung Electronics Co., Ltd, Suwon-si, Gyeonggi-do 16677 (KR)
(72) Inventor: KIM, Junhyoung, 16677 Suwon-si (KR); KANG, Bumkyu, 16677 Suwon-si (KR); PARK, Junyong, 16677 Suwon-si (KR); SUNG, Sukkang, 16677 Suwon-si (KR)
(74) Representative: Marks & Clerk LLP

(57) **Abstract**

A semiconductor device and a data storage system are provided. The semiconductor device includes a peripheral circuit structure; a stack structure vertically overlapping the peripheral circuit structure; and a separation structure penetrating through the stack structure. The stack structure includes a plurality of blocks spaced apart from each other by a first portion of the separation structure, each of the plurality of blocks includes insulating layers and conductive layers alternately stacked in a vertical direction, and the plurality of blocks include first blocks and a plurality of capacitor blocks disposed between first blocks adjacent to each other among the first blocks.

## Description

### BACKGROUND

Some example embodiments of the present disclosure relate to a semiconductor device and/or a data storage system including the same.

Demand exists for semiconductor device able to store high-capacity data in a data storage system. Accordingly, a method for increasing data storage capacity of a semiconductor device has been researched. For example, as a method for increasing data storage capacity of a semiconductor device, a semiconductor device including memory cells disposed three-dimensionally, instead of memory cells disposed two-dimensionally, has been suggested.

### SUMMARY

An example embodiment of the present disclosure is to provide a semiconductor device having increased integration density.

An example embodiment of the present disclosure is to provide a data storage system including a semiconductor device having increased integration density.

According to an example embodiment of the present disclosure, a semiconductor device includes a peripheral circuit structure; a stack structure vertically overlapping the peripheral circuit structure; and a separation structure penetrating through the stack structure, wherein the stack structure includes a plurality of blocks spaced apart from each other by the separation structure, wherein each of the plurality of blocks includes insulating layers and conductive layers alternately stacked in a vertical direction, and wherein the plurality of blocks include first blocks and a plurality of capacitor blocks disposed between first blocks adjacent to each other among the first blocks.

According to an example embodiment of the present disclosure, a semiconductor device includes a first chip structure; and a second chip structure vertically overlapping the first chip structure, wherein the first chip structure includes peripheral circuits, wherein the second chip structure includes a stack structure; a separation structure penetrating through the stack structure; a plurality of contact plugs; and input/output pads, wherein the stack structure includes a plurality of blocks spaced apart from each other, wherein each of the plurality of blocks includes insulating layers and conductive layers alternately stacked in a vertical direction, wherein the plurality of blocks include a plurality of memory blocks and capacitor blocks, wherein the first and second chip structures further include a routing interconnection structure between the peripheral circuits and the stack structure, wherein the plurality of contact plugs include a first input/output contact plug penetrating through the stack structure and electrically connected to a first input/output pad of the input/output pads, wherein the capacitor block includes a first capacitor electrode including a plurality of first conductive layers among the conductive layers and a second capacitor electrode including a plurality of second conductive layers among the conductive layers, and wherein the first capacitor electrode is electrically connected to the first input/output pad through the first input/output contact plug and the routing interconnection structure.

According to an example embodiment of the present disclosure, a data storage system includes a semiconductor device including input/output pad; and a controller electrically connected to the semiconductor device through the input/output pad and controlling the semiconductor device, wherein the semiconductor device further includes a peripheral circuit structure; a stack structure vertically overlapping the peripheral circuit structure; and a separation structure penetrating through the stack structure, wherein each of the plurality of blocks include insulating layers and conductive layers alternately stacked in the vertical direction, wherein the plurality of blocks include first blocks and a plurality of capacitor blocks disposed between first blocks adjacent to each other among the first blocks, and wherein the plurality of capacitor blocks are spaced apart from each other by the separation structure.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIGS. 1A to 8D are diagrams illustrating a semiconductor device according to an example embodiment of the present disclosure;
FIG. 9 is a diagram illustrating a modified example of a semiconductor device according to an example embodiment of the present disclosure, viewed from above;
FIG. 10A is an enlarged cross-sectional diagram illustrating a modified example of a portion of a semiconductor device according to an example embodiment of the present disclosure, viewed from above;
FIG. 10B is an enlarged cross-sectional diagram illustrating a modified example of a portion of a semiconductor device according to an example embodiment of the present disclosure, viewed from above;
FIG. 10C is an enlarged cross-sectional diagram illustrating a modified example of a portion of a semiconductor device according to an example embodiment of the present disclosure, viewed from above;
FIG. 10D is an enlarged cross-sectional diagram illustrating a modified example of a portion of a semiconductor device according to an example embodiment of the present disclosure, viewed from above;
FIG. 10E is an enlarged cross-sectional diagram illustrating a modified example of a portion of a semiconductor device according to an example embodiment of the present disclosure, viewed from above;
FIG. 10F is an enlarged cross-sectional diagram illustrating a modified example of a portion of a semiconductor device according to an example embodiment of the present disclosure, viewed from above;
FIG. 10G is an enlarged cross-sectional diagram illustrating a modified example of a portion of a semiconductor device according to an example embodiment of the present disclosure, viewed from above;
FIG. 11 is an enlarged cross-sectional diagram illustrating a modified example of a portion of a semiconductor device according to an example embodiment of the present disclosure, viewed from above;
FIG. 12A is an enlarged cross-sectional diagram illustrating a modified example of a portion of a semiconductor device according to an example embodiment of the present disclosure, viewed from above;
FIG. 12B is an enlarged cross-sectional diagram illustrating a modified example of a portion of a semiconductor device according to an example embodiment of the present disclosure, viewed from above;
FIG. 12C is an enlarged cross-sectional diagram illustrating a modified example of a portion of a semiconductor device according to an example embodiment of the present disclosure, viewed from above;
FIG. 12D is an enlarged cross-sectional diagram illustrating a modified example of a portion of a semiconductor device according to an example embodiment of the present disclosure, viewed from above;
FIGS. 13, 14A and 14B are diagrams illustrating modified examples of a semiconductor device according to an example embodiment of the present disclosure, viewed from above;
FIGS. 15, 16A and 16B are diagrams illustrating modified examples of a semiconductor device according to an example embodiment of the present disclosure, viewed from above;
FIG. 17 is a cross-sectional diagram illustrating a modified example of a semiconductor device according to an example embodiment of the present disclosure;
FIG. 18 is a diagram illustrating a modified example of a semiconductor device according to an example embodiment of the present disclosure, viewed from above;
FIG. 19 is a diagram illustrating a modified example of a semiconductor device according to an example embodiment of the present disclosure, viewed from above;
FIG. 20 is a perspective diagram illustrating a modified example of a semiconductor device according to an example embodiment of the present disclosure;
FIGS. 21A and 21B are diagrams illustrating a modified example of a semiconductor device according to an example embodiment of the present disclosure;
FIGS. 22A, 22B and 23 are diagrams illustrating a modified example of a semiconductor device according to an example embodiment of the present disclosure;
FIGS. 24, 25, 26A, 26B, 26C, 27A and 27B are diagrams illustrating a modified example of a semiconductor device according to an example embodiment of the present disclosure;
FIG. 28 is a flowchart illustrating an example of a method of manufacturing a semiconductor device according to an example embodiment of the present disclosure; and
FIG. 29 is a diagram illustrating a data storage system including a semiconductor device according to an example embodiment of the present disclosure.

### DETAILED DESCRIPTION

Hereinafter, embodiments of the present disclosure will be described as follows with reference to the accompanying drawings. Hereinafter, terms such as "upper portion," "middle portion," and "lower portion" may be replaced with other terms, for example, "first," "second," and "third" to describe elements of the specification. Terms such as "first," "second," and "third" may be used to describe different elements, but the elements are not limited by the terms, and a "first element" may be referred to as a "second element."

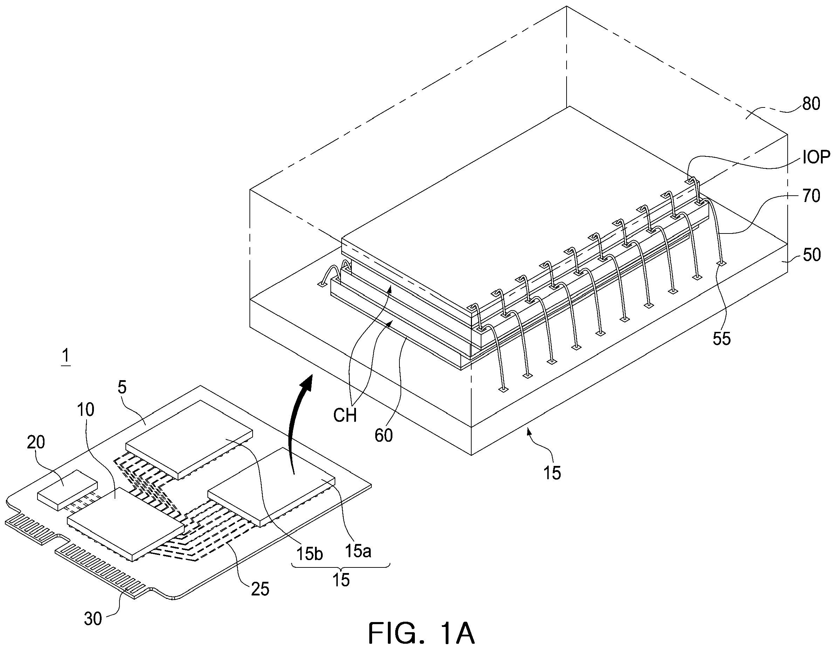

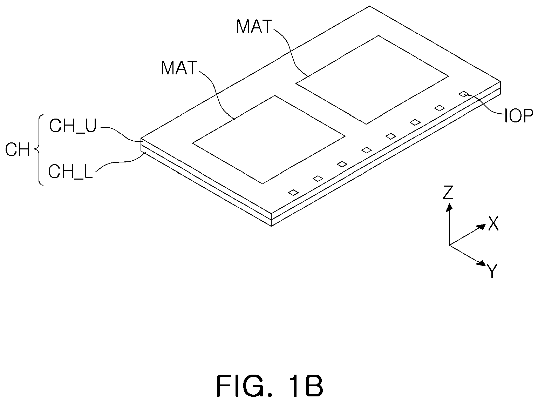

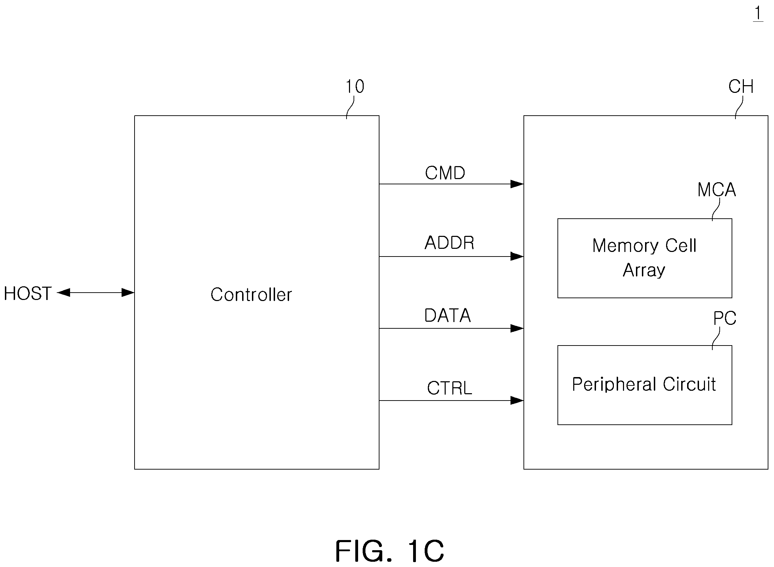

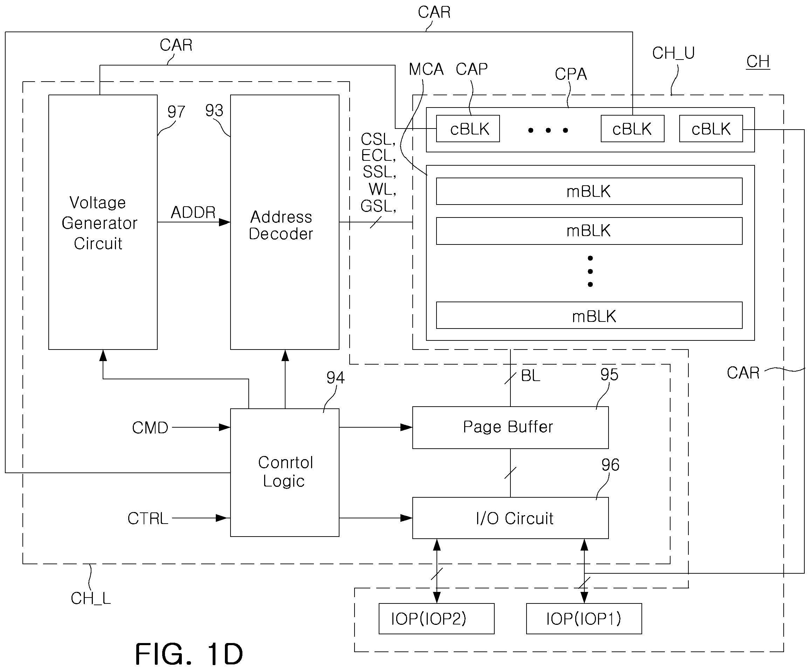

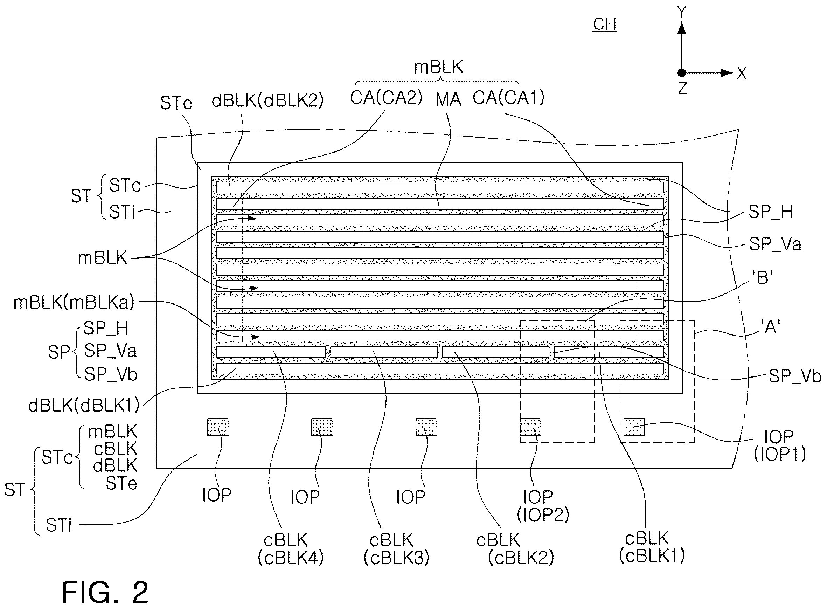

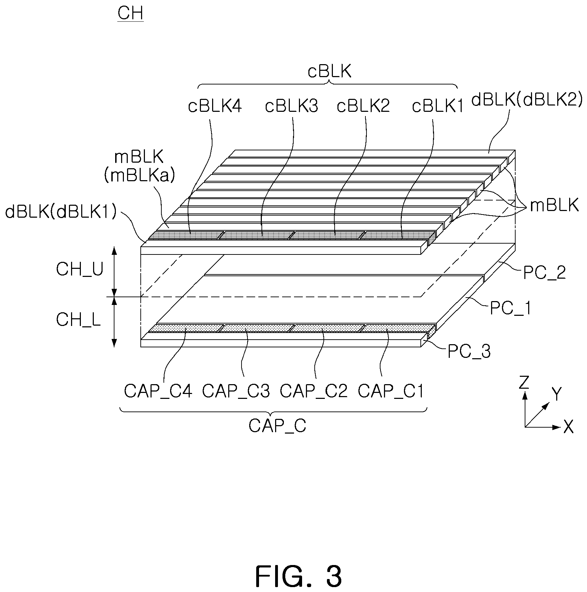

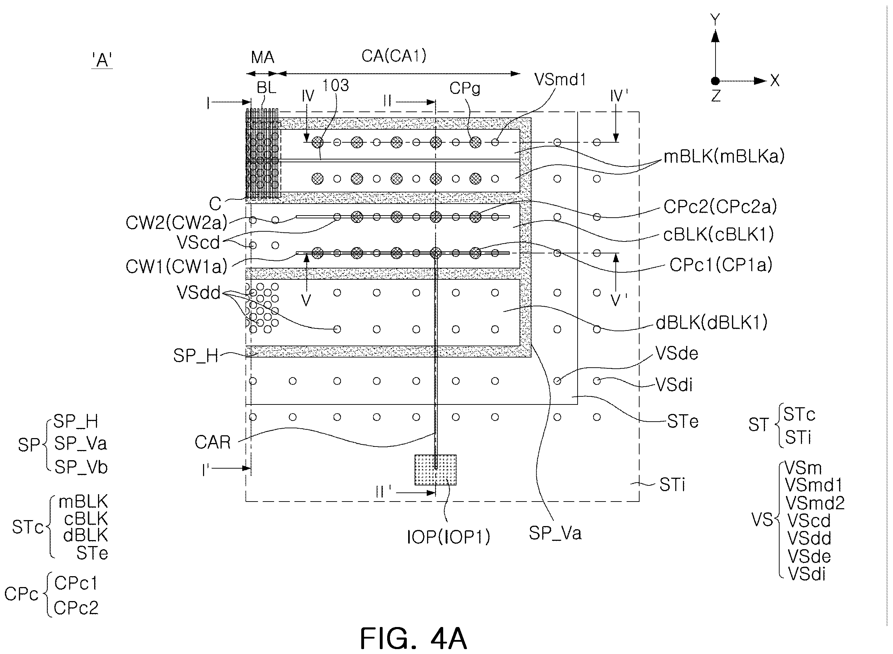

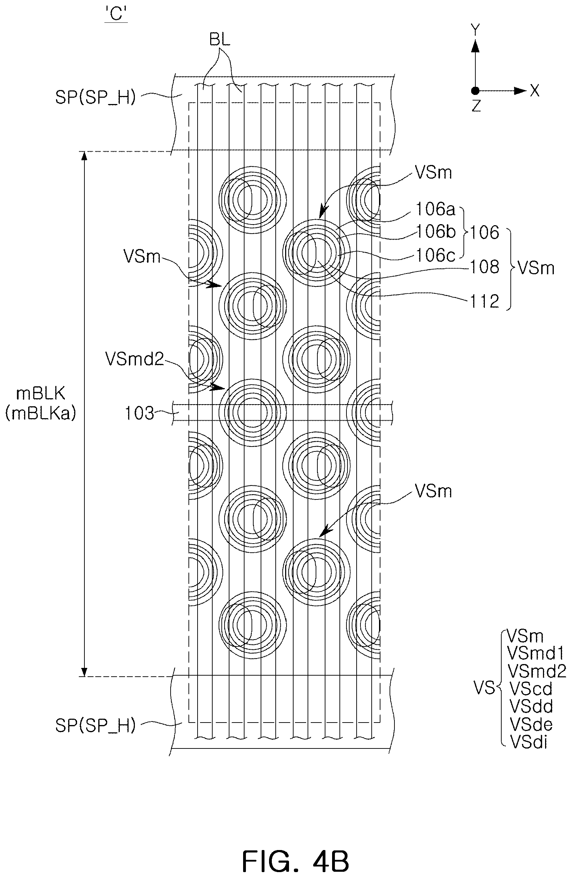

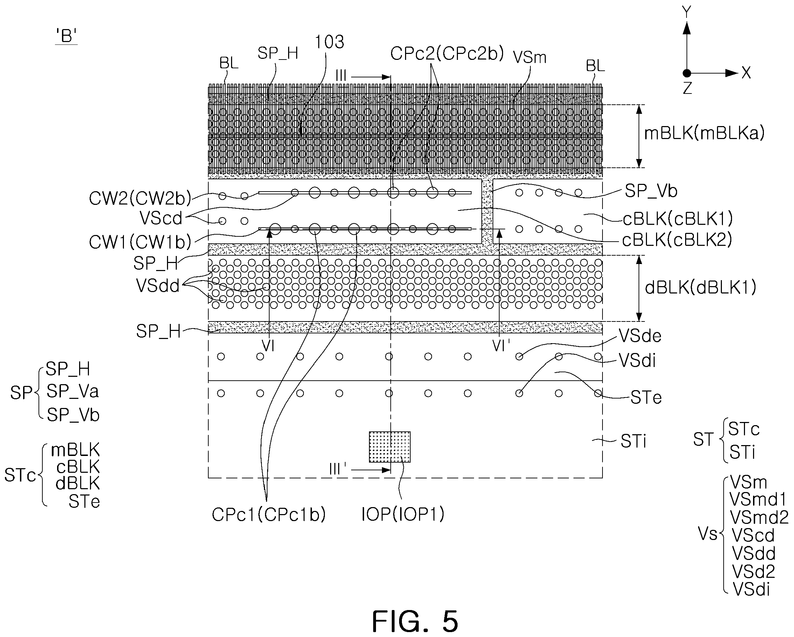

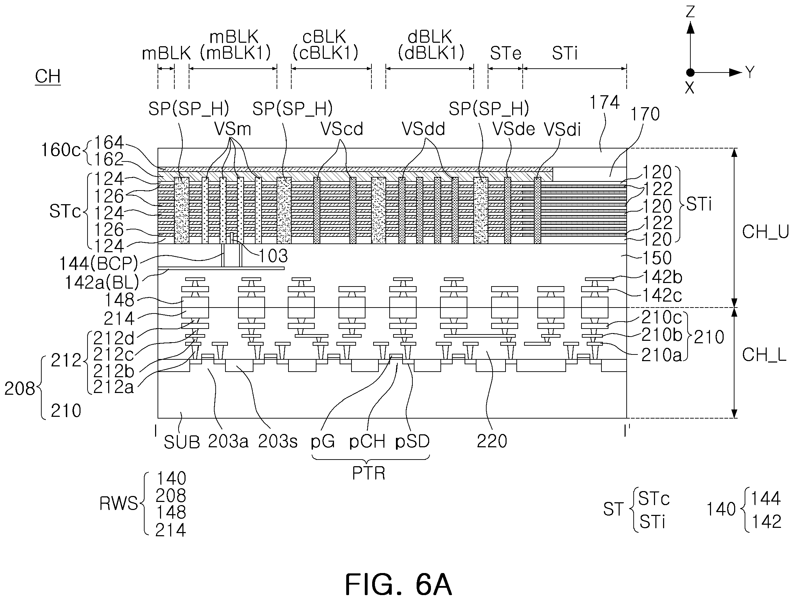

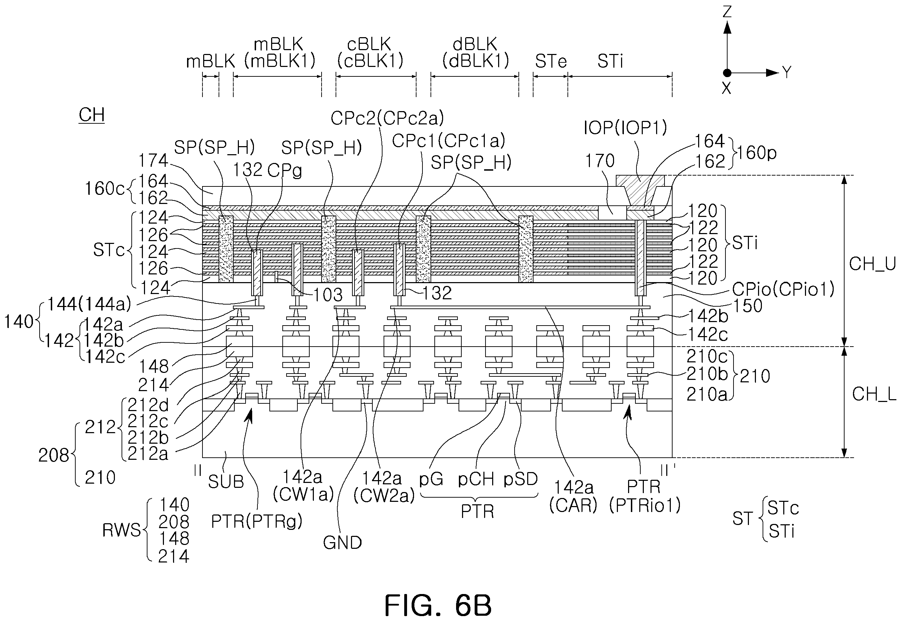

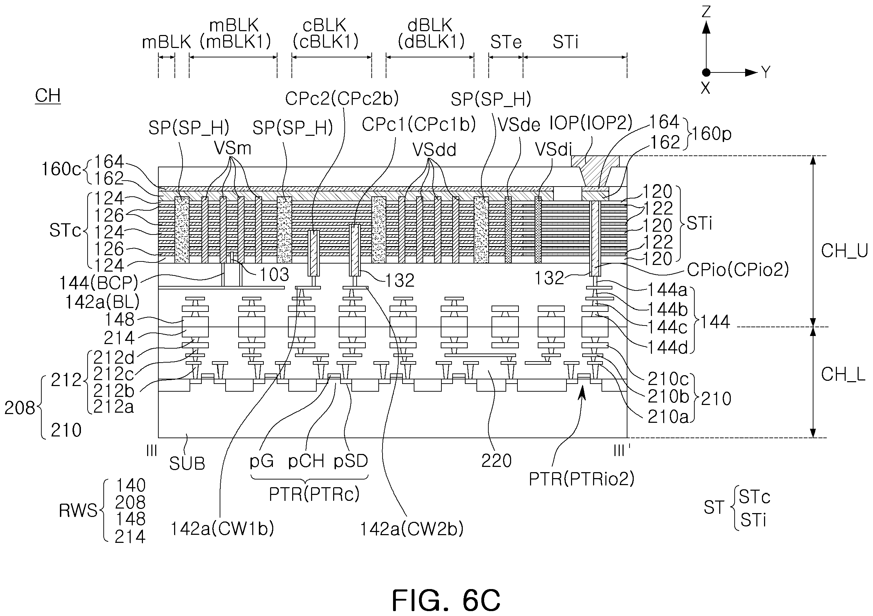

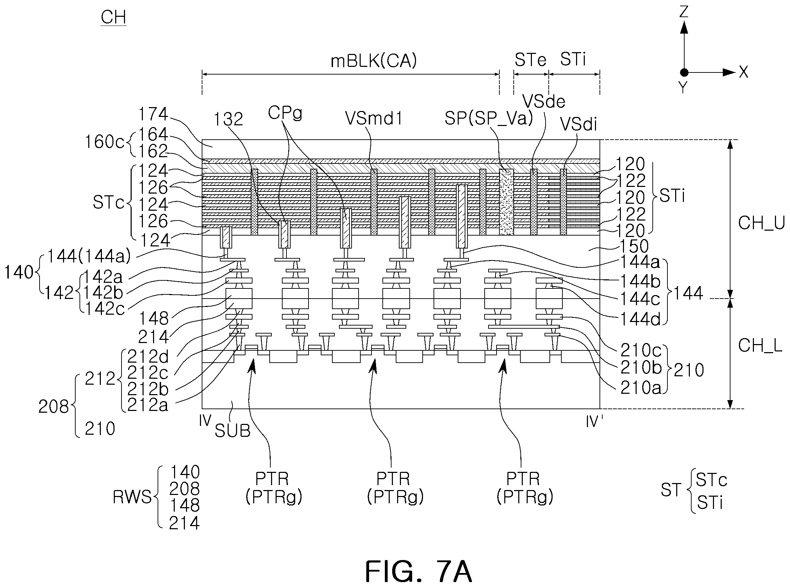

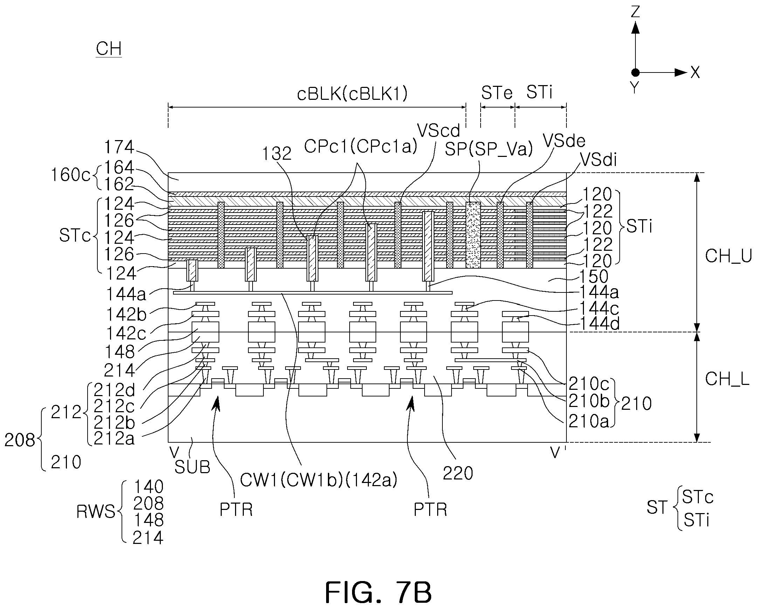

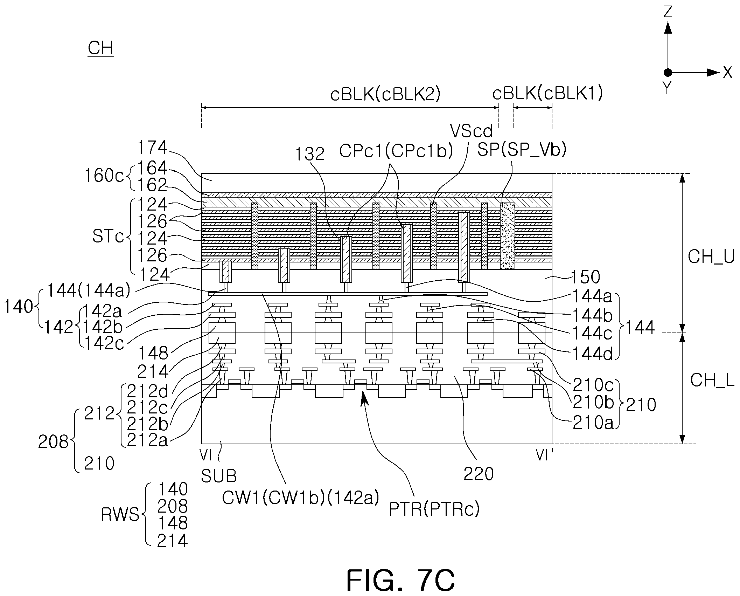

A semiconductor device according to an example embodiment will be described with reference to FIGS. 1A to 7C. FIG. 1A is a perspective diagram illustrating a data storage system including a semiconductor device according to an example embodiment, FIG. 1B is a perspective diagram illustrating a semiconductor device according to an example embodiment, FIG. 1C is a diagram illustrating a data storage system including a semiconductor device according to an example embodiment, FIG. 1D is a block diagram illustrating a semiconductor device according to an example embodiment, FIG. 2 is a diagram illustrating a portion of a semiconductor device according to an example embodiment, FIG. 3 is a perspective diagram illustrating a portion of a semiconductor device according to an example embodiment, FIG. 4A is an enlarged diagram illustrating region "A" in FIG. 2, FIG. 4B is an enlarged diagram illustrating region "C" in FIG. 4A, FIG. 5 is a diagram illustrating region "B" in FIG. 2, FIG. 6A is a cross-sectional diagram illustrating a region taken along line I-I' in FIG. 4A, FIG. 6B is a cross-sectional diagram illustrating a region taken along line II-II' in FIG. 4A, FIG. 6C is a cross-sectional diagram illustrating a region taken along line III-III' in FIG. 5, 7A is a cross-sectional diagram illustrating a region taken along line IV-IV' in FIG. 4A, FIG. 7B is a cross-sectional diagram illustrating a region taken along line V-V' in FIG. 4A, and FIG. 7C is a cross-sectional diagram illustrating a region taken along line IV-IV' in FIG. 5.

Referring to 1A, 1B and 1C, a data storage system 11 according to an example embodiment may include a main substrate 5, a controller 10 mounted on the main substrate 5, one or more semiconductor packages 15, and a DRAM 20. The semiconductor package 15 and the DRAM 20 may be connected to the controller 10 by interconnection patterns 25 formed on the main substrate 5.

The main substrate 5 may include a connector 30 including a plurality of pins configured to be coupled to an external host (HOST in FIG. 1C). The number of the plurality of pins and the arrangement of the plurality of pins in the connector 30 may vary a communication interface between the data storage system 1 and the external host HOST.

In example embodiments, the data storage system 1 may communicate with an external host in accordance with Interfaces such as universal serial bus (USB), peripheral component interconnect express (PCI-Express), serial advanced technology attachment (SATA), and M-Phy for universal flash storage (UFS).

In example embodiments, the data storage system 1 may operate by power supplied from the external host (HOST in FIG. 1C) through the connector 30.

The data storage system 1 may further include a power management integrated circuit (PMIC) distributing power supplied from the external host HOST to the controller 10 and the semiconductor package 15.

The controller 10 may write data to the semiconductor package 15 or may read data from the semiconductor package 15, and may improve an operation speed of the data storage system 1.

The DRAM 20 may be configured as a buffer memory to alleviate a difference in speeds between the semiconductor package 15, which is a data storage space, and an external host. The DRAM 20 included in the data storage system 1 may also operate as a cache memory and may provide a space for temporarily storing data during a control operation for the semiconductor package 15. When the data storage system 1 includes the DRAM 20, the controller 10 may further include a DRAM controller for controlling the DRAM 20 in addition to a NAND controller for controlling the semiconductor package 15.

The semiconductor package 15 may include first and second semiconductor packages 15a and 15b spaced apart from each other. Each of the first and second semiconductor packages 15a and 15b may be configured as a semiconductor package including a plurality of semiconductor devices CH.

The semiconductor devices CH may also be referred to as semiconductor chips.

Each of the first and second semiconductor packages 15a and 15b may include a package substrate 50, semiconductor devices CH on the package substrate 50, adhesive layers 60 disposed on a lower surface of each of the semiconductor devices CH, a connection structure 70 electrically connecting the semiconductor devices CH to the package substrate 50, and a molding layer 80 covering the semiconductor devices CH and the connection structure 70 on the package substrate 50.

The package substrate 50 may be configured as a printed circuit board including package upper pads 55. Each of the semiconductor devices CH may include input/output pads IOP.

In example embodiments, the connection structure 70 may be configured as a bonding wire electrically connecting the input/output pad IOP to the package upper pads 55. Accordingly, in each of the first and second semiconductor packages 15a and 15b, the semiconductor devices CH may be electrically connected to each other using a bonding wire method and may be electrically connected to the package upper pads 55 of the package substrate 50. In example embodiments, in each of the first and second semiconductor packages 15a and 15b, the semiconductor devices CH may be electrically connected to each other by a connection structure including a through silicon via (TSV), instead of the connection structure 70 of the bonding wire method.

In example embodiments, the controller 10 and the semiconductor devices CH may be included in a package. For example, the controller 10 and the semiconductor devices CH may be mounted on an interposer substrate different from the main substrate 5, and the controller 10 and the semiconductor devices CH may be connected to each other by an interconnection formed on the interposer substrate.

Each of the semiconductor devices CH may include a first chip structure CH_L and a second chip structure CH_U on the first chip structure CH_L.

In each of the semiconductor devices CH, the second chip structure CH_U may include a plurality of memory mats MAT spaced apart from each other. In each of the semiconductor devices CH, the second chip structure CH_U may include input/output pads IOP.

Each of the semiconductor devices CH may include a memory cell array MCA and a peripheral circuit PC. In each of the semiconductor devices CH, each of the plurality of memory mats MAT of the second chip structure CH_U may include the memory cell array MCA, and a portion of the second chip structure CH_U and the first chip structure CH_L may include the peripheral circuit PC.

In the description below, the semiconductor device CH will be mainly described. Also, a memory mat among the plurality of memory mats MAT of the semiconductor device CH will be mainly described.

The controller 10 may write data DATA to the semiconductor device CH or may read data DATA stored in the semiconductor device CH. The controller 10 may transmit a command CMD, an address ADDR, a control signal CTRL and a data DATA to the semiconductor device CH in order to write data DATA to the semiconductor device CH. The controller 10 may transmit the command CMD, the address ADDR, and the control signal CTRL to the semiconductor device CH in order to read data DATA stored in the semiconductor device CH.

The semiconductor device CH may include non-volatile memory devices such as NAND flash memory, phase change memory (PRAM), resistance memory (ReRAM), or magnetoresistive memory (MRAM). The semiconductor device CH may perform operations such as operations of writing, reading, erasing data DATA in response to signals received from the controller 10.

In the second chip structure CH_U, the memory cell array MCA may be arranged three-dimensionally and may include memory cells for storing data.

Referring to FIG. 1D along with FIGS. 1A, 1B, and 1C, in the semiconductor device CH, the second chip structure CH_U may include a plurality of memory blocks mBLK and a plurality of capacitor blocks cBLK. The plurality of memory blocks mBLK may be included in the memory cell array MCA. The plurality of capacitor blocks cBLK may be included in a capacitor array CPA. Each of the plurality of capacitor blocks cBLK may include at least one capacitor CAP.

The semiconductor device CH may include an address decoder 93, a control logic 94, a page buffer 95, an input/output circuit 96, and a voltage generator circuit 97.

The peripheral circuit (PC in FIG. 1C) may include the address decoder 93, the control logic 94, the page buffer 95, the input/output circuit 96, and the voltage generator circuit 97.

At least one of the address decoder 93, the control logic 94, the page buffer 95, the input/output circuit 96, and the voltage generator circuit 97 in the first chip structure CH_L may be included in a circuit together with the capacitors CAP in the second chip structure CH_U. For example, the voltage generator circuit 97 may be included in a circuit including a capacitor CAP of at least one capacitor block cBLK among the plurality of capacitor blocks cBLK. For example, the voltage generator circuit 97 may convert an externally input voltage into a level most suitable for operation of the semiconductor device CH and may supply power to drive each circuit. Accordingly, the peripheral circuit (PC in FIG. 1C) may include the address decoder 93, the control logic 94, the page buffer 95, the input/output circuit 96, and the voltage generator circuit 97 along with the capacitors CAP. Portions of the address decoder 93, the control logic 94, the page buffer 95, the input/output circuit 96, and the voltage generator circuit 97 disposed in the first chip structure CH_L may be electrically connected through the plurality of capacitor blocks cBLK and capacitor routing interconnections CAR disposed in the second chip structure CH_U.

The second chip structure CH_U may further include word lines WL, string selection lines SSL, ground selection lines GSL, bit lines BL, erase control lines ECL, and a common source CSL. The memory cell array MCA may be connected to the word lines WL, the string selection lines SSL, the ground selection lines GSL, the bit lines BL, and the erase control lines ECL, and the common source CSL.

The memory cell array MCA may be connected to the address decoder 93 through the word lines WL, the string selection lines SSL, the ground selection lines GSL and the common source CSL, and may be connected to the page buffer 95 through the bit lines BL.

The address decoder 93 may select one of the plurality of memory blocks mBLK of the memory cell array MCA. The address decoder 93 may select one of the word lines WL of the selected memory block. The address decoder 93 may transmit the voltages provided by the voltage generator circuit 97 to the word line WL or selection lines SSL and GSL of the selected memory block. The address decoder 93 may transfer a positive (+) high voltage program voltage to the selected word line during a program operation, and may transfer a positive (+) high voltage erase voltage to a bulk of the selected memory block during an erase operation.

The control logic 94 may receive a command CMD and a control signal CTRL from the controller 10, and may control the address decoder 93, the page buffer 95, and the input/output circuit 96 in response to the received signals. The control logic 94 may control the voltage generator circuit 97 generating various voltages required for the semiconductor device CH to operate. For example, control logic 94 may adjust a voltage level provided by word lines WL and bit lines BL when performing memory operations such as a program operation or an erase operation.

The voltage generator circuit 97, which may be included in a circuit including a capacitor of at least one capacitor block among the plurality of capacitor blocks cBLK, may generate voltages of various levels such as a plurality of selected read voltages, a plurality of non-selected read voltages, a plurality of program pulses, a plurality of pass voltages, and a plurality of erase pulses under control of the control logic 94, and may provide voltages to the address decoder 93 and the memory cell array MCA. For example, the voltage generator circuit 97 may generate a positive (+) high voltage corresponding to a plurality of program pulses or a plurality of erase pulses.

The voltage generator circuit 97 may include a charge pump including at least one pumping capacitor in order to generate voltages of various levels as described above. The pumping capacitor of the voltage generator circuit 97 may be configured as a capacitor of at least one capacitor block among the plurality of capacitor blocks cBLK1, cBLK2, ..., cBLKm in the second chip structure CH_U.

The page buffer 95 may operate as a write driver or a sense amplifier depending on the operation mode. During a read operation, the page buffer 95 may sense the bit line BL of the selected memory cell under control of the control logic 94. Sensed data may be stored in latches provided in the page buffer 95. The page buffer 95 may dump the data stored in latches into the input/output circuit 96 under control of the control logic 94.

The input/output circuit 96 may temporarily store the command CMD, the address ADDR, the control signal CTRL and the data DATA provided through the input/output pads IOP from an external entity, present externally of the semiconductor devices CH. The input/output circuit 96 may temporarily store read data of the semiconductor device CH and may output the data to an external entity through the input/output pads IOP at a designated time point.

The input/output pads IOP may include a first input/output pad IOP1 connected to the first capacitor of the first capacitor block among the plurality of capacitor blocks cBLK and a second input/output pad IOP2 not connected to capacitors of the plurality of capacitor blocks cBLK.

By connecting the first capacitor of the first capacitor block cBLK to the first input/output pad IOP1, noise of the signal transmitted through the first input/output pad IOP1 may be reduced. By connecting the first capacitor of the first capacitor block cBLK to the first input/output pad IOP1, the first capacitor may act as a damper when an input/output speed (IO speed) increases.

In the description below, a portion of elements of the semiconductor device CH will be described with reference to FIGS. 2 and 3. FIG. 2 illustrates a portion of the second chip structure CH_U, mainly illustrating the input/output pads IOP, along with the memory cell array MCA of a memory mat adjacent to the input/output pads IOP among the plurality of memory mats MAT in FIG. 1B, and FIG. 3 is a perspective diagram illustrating a portion of elements of the semiconductor device CH.

Referring to FIGS. 2 and 3, along with FIGS. 1A to 1D, the second chip structure (CH_U in FIG. 1B) of the semiconductor device CH may include a stack structure ST including a conductive stack region STc and an insulating stack region STI.

The second chip structure (CH_U in FIG. 1B) of the semiconductor device CH may further include a separation structure SP penetrating through the stack structure ST in a vertical direction Z. The vertical direction Z may be a direction perpendicular to an upper surface of the substrate SUB. The stack structure ST may be stacked in the vertical direction Z. Horizontal directions (e.g. a first direction X and a second direction Y) may be defined perpendicular to the vertical direction Z. The first direction X and the second direction Y may be perpendicular to each other. The vertical direction Z may define a height direction. Accordingly, features that are described as "above" other features may be located further along the vertical direction Z than the other features. Similarly, an "upper" portion of a component may be located further along the vertical direction Z than a "lower" portion of the component. It will be appreciated that the terms "vertical", "horizontal", "upper" and "lower" are relative to the structure of the substrate, and do not imply any particular orientation of the semiconductor device CH in use.

The separation structure SP may include first horizontal portions SP_H extending in the first direction X and second and third horizontal portions SP_Va and SP_Vb extending in the second direction Y perpendicular to the first direction X.

The conductive stack region STc may include a plurality of blocks mBLK, dBLK, cBLK, and STe spaced apart from each other by the separation structure SP.

The plurality of blocks mBLK, dBLK, cBLK, and STe may include the plurality of memory blocks mBLK and the plurality of capacitor blocks cBLK described with reference to FIG. 1D.

The plurality of blocks mBLK, dBLK, cBLK, and STe may further include at least one dummy block dBLK and an edge block STe.

The edge block STe may have a quadrangular ring shape surrounding an external side of the separation structure SP and may be in contact with the insulating stack region STi. The edge block STe may surround the plurality of memory blocks mBLK, the plurality of capacitor blocks cBLK and the at least one dummy block dBLK.

The plurality of blocks mBLK, dBLK, cBLK, and STe may include first blocks mBLK and dBLK. The plurality of capacitor blocks cBLK may be disposed between first blocks adjacent to each other among the first blocks mBLK and dBLK.

The at least one dummy block dBLK may include a first dummy block dBLK_1 and a second dummy block dBLK_2. Each of the plurality of memory blocks mBLK, the first dummy block dBLK_1 and the second dummy block dBLK_2 may have a line shape extending in the first direction X. Each of the plurality of capacitor blocks cBLK may have a line shape or a bar shape extending in the first direction X. In the first direction X, a length of each of the plurality of memory blocks mBLK may be greater than a length of each of the plurality of capacitor blocks cBLK.

The plurality of memory blocks mBLK and the plurality of capacitor blocks cBLK may be disposed between the first dummy block dBLK_1 and the second dummy block dBLK_2.

Each of the plurality of memory blocks mBLK may include a memory region MA and at least one connection region CA. For example, the at least one connection region CA may include a first connection region CA1 and a second connection region CA2 disposed on both sides of the memory region MA. The first connection region CA1 may be spaced apart from the second connection region CA2 in the first direction X, with the memory region MA therebetween.

The plurality of capacitor blocks cBLK may be arranged to be spaced apart from each other in the first direction X. The plurality of capacitor blocks cBLK may include a first capacitor block cBLK1, a second capacitor block cBLK2, a third capacitor block cBLK3, and a fourth capacitor block cBLK4. Having said this, the number of capacitor blocks may vary.

The plurality of capacitor blocks cBLK may be spaced apart from each other by the second horizontal portions SP_Va of the separation structure SP.

A side surface of at least one capacitor block among the plurality of capacitor blocks cBLK may be surrounded by the separation structure SP. For example, the entire side surfaces of each of the plurality of capacitor blocks cBLK may be surrounded by the separation structure SP. The tern "side surface" may refer to any surface that faces a horizontal direction (e.g. that runs along the vertical direction Z). Side surfaces of an object may surround the object in a horizontal plane (e.g. may define the extent of the object in the first direction X and second direction Y).

Among the first and second dummy blocks dBLK_1 and dBLK_2, the first dummy block dBLK_1 may be adjacent to the plurality of capacitor blocks cBLK in the second direction Y. Among the plurality of memory blocks mBLK, the first memory block mBLKa may be adjacent to the plurality of capacitor blocks cBLK in the second direction Y. The plurality of capacitor blocks cBLK may be disposed between the first memory block mBLKa and the first dummy block dBLK1 in the second direction Y.

The first chip structure CH_L may include a plurality of lower circuits PC_1, PC_2, PC_3, and CAP_C. The plurality of lower circuits PC_1, PC_2, PC_3, and CAP_C may include a first lower circuit PC_1, a second lower circuit PC_2, a third lower circuit PC_3, and fourth lower circuits CAP_C. The plurality of lower circuits PC_1, PC_2, PC_3, and CAP_C may be included in a peripheral circuit structure, and the plurality of lower circuits PC_1, PC_2, PC_3, and CAP_C may be configured as peripheral circuits. The number of the plurality of lower circuits may vary.

The plurality of lower circuits PC_1, PC_2, PC_3, and CAP_C may overlap the plurality of blocks mBLK, cBLK, and dBLK in the vertical direction Z. A component that "overlaps" another component in the vertical direction Z may be positioned such that a line parallel to the vertical direction can be defined that passes through at least a portion of each of the component and the other component.

Each of the plurality of capacitor blocks cBLK may include the capacitor (CAP in FIG. 1D) described above.

The first and second lower circuits PC_1 and PC_2 may be included in the page buffer (95 in FIG. 1D) and the address decoder (93 in FIG. 1D) described above. For example, the first lower circuit PC_1 may be included in the address decoder (93 in FIG. 1D), and the second lower circuit PC_2 may be included in the page buffer (95 in FIG. 1D).

At least one of the third and fourth lower circuits (PC_3 and CAP_C in FIG. 3) together with the capacitors of the plurality of capacitor blocks (cBLK in FIG. 3) may be included in at least one of the control logic (94 in FIG. 1D), the input/output circuit (96 in FIG. 1D), and the voltage generator circuit (97 in FIG. 1D) forming a circuit, including the capacitors (CAP in FIG. 1D) of the plurality of capacitor blocks (cBLK in FIG. 1D) described above. For example, the third lower circuit PC_3 may be included in the input/output circuit (96 in FIG. 1D), and the fourth lower circuits CAP_C may be included in the control logic (94 in FIG. 1D) and/or the voltage generator circuit (97 in FIG. 1D).

The fourth lower circuits CAP_C, which may be electrically connected to the capacitors (CAP in FIG. 1D) of the plurality of capacitor blocks cBLK, may include a first capacitor connection circuit CAP_C1, which may be electrically connected to the first capacitor of the first capacitor block cBLK1, a second capacitor connection circuit CAP_C2, which may be electrically connected to the second capacitor of the second capacitor block cBLK2, a third capacitor connection circuit CAP_C3, which may be electrically connected to the third capacitor of the third capacitor block cBLK3, and a fourth capacitor connection circuit CAP_C4, which may be electrically connected to the fourth capacitor of the fourth capacitor block cBLK4. Among the peripheral circuits, the first capacitor connection circuit CAP_C1 may be configured as a first peripheral circuit, the second capacitor connection circuit CAP_C2 may be configured as a second peripheral circuit, the third capacitor connection circuit CAP_C3 may be configured as a third peripheral circuit, and the fourth capacitor connection circuit CAP_C4 may be configured as a fourth peripheral circuit. One capacitor connection circuit CAP_C1, CAP_C2, CAP_C3 and CAP_C4 may be provided for each capacitor block cBLK1, cBLK2, cBLK3 and cBLK4.

In the first chip structure CH_L, at least a portion of at least one of the fourth lower circuits CAP_C electrically connected to capacitors CAP of the plurality of capacitor blocks cBLK may vertically overlap at least a portion of at least one of the plurality of capacitor blocks cBLK. For example, the first capacitor connection circuit CAP_C1 among the fourth lower circuits CAP_C, which may be peripheral circuits, may form a circuit by being electrically connected to the first capacitor of the first capacitor block cBLK1, and the first capacitor connection circuit CAP_C1 may vertically overlap at least a portion of the first capacitor of the first capacitor block cBLK1.

In the description below, an example embodiment of the semiconductor device CH will be described with reference to FIGS. 1A to 3, FIGS. 4A, 4B, 5, 6A, 6B, 6C, 7A, 7B, and 7C.

Referring to FIGS. 1A to 3, FIGS. 4A, 4B, 5, 6A to 6C, and 7A to 7C, the first chip structure CH_L may include a substrate SUB, peripheral active regions 203A on the substrate SUB, and a peripheral device separation region 203s defining the peripheral active regions 203a on the substrate SUB. The substrate SUB may be a semiconductor substrate.

The first chip structure CH_L may further include peripheral transistors PTR, a lower interconnection structure 208, a lower insulating structure 220 and lower bonding pads 214 on the substrate SUB.

Each of the peripheral transistors PTR may include peripheral source/drain regions pSD spaced apart from each other in the peripheral active regions 203a, a peripheral channel region PCH disposed between the peripheral source/drain regions pSD within the peripheral active regions 203a, and a peripheral gate pG on the peripheral channel region PCH.

The lower interconnection structure 208 may be electrically connected to the peripheral transistors PTR.

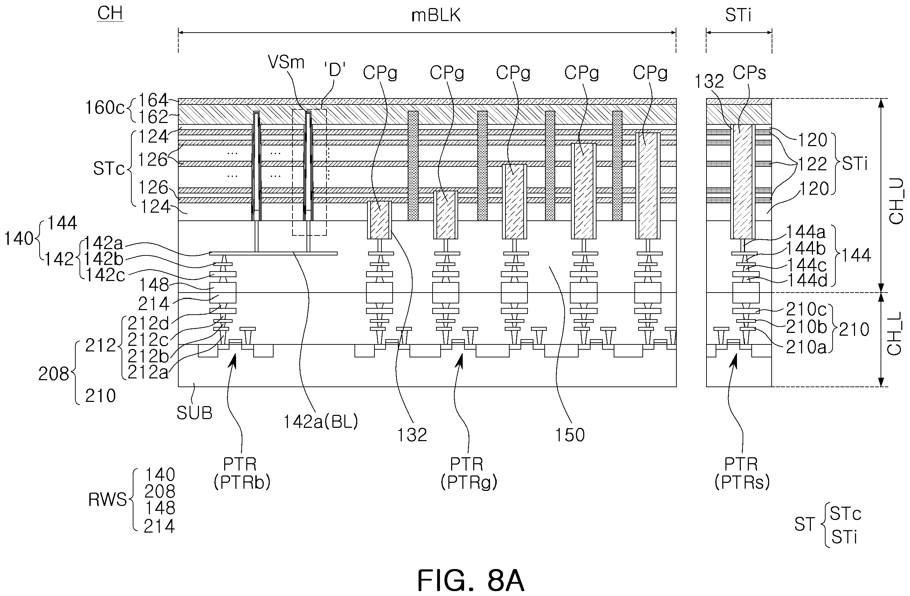

The electrical connection relationship between the peripheral transistors PTR will be described later with reference to FIGS. 8A to 8D.

The lower interconnection structure 208 may include a plurality of lower horizontal portions 210 disposed on different levels, and a plurality of lower vertical portions 212 disposed on different levels.

Each of the plurality of lower horizontal portions 210 may be configured as a lower interconnection line or lower pad. For example, the plurality of lower horizontal portions 210 may be referred to as lower interconnections or lower pads. The plurality of lower vertical portions 212 may be referred to as lower vias or lower contact plugs.

The plurality of lower horizontal portions 210 may include first lower horizontal portions 210a, second lower horizontal portions 210b on first lower horizontal portions 210a, and third lower horizontal portions 210c on second lower horizontal portions 210b.

The plurality of lower vertical portions 212 may include first lower vertical portions 212a below the first lower horizontal portions 210a, second lower vertical portions 212b between the first lower horizontal portions 210a and the second lower horizontal portions 210b, third lower vertical portions 212c between the second lower horizontal portions 210b and the third lower horizontal portions 210c, and fourth lower vertical portions 212d on the third lower horizontal portions 210c.

The lower bonding pads 214 may be electrically connected to the lower interconnection structure 208 on the lower interconnection structure 208.

The lower insulating structure 220 may cover the peripheral transistors PTR and the lower interconnection structure 208 on the peripheral active regions 203A and the peripheral device separation region 203s, and may cover side surfaces of the lower bonding pads 214. The upper surface of the lower insulating structure 220 may be coplanar with the upper surfaces of the lower bonding pads 214.

The second chip structure CH_U may include the stack structure ST and the separation structure SP described with reference to FIG. 2. As described with reference to FIG. 2, the stack structure ST may include the conductive stack region STc and the insulating stack region STi, and the conductive stack region STc may include a plurality of blocks mBLK, dBLK, cBLK, and STe spaced apart from each other by the separation structure SP.

The stack structure ST may vertically overlap the peripheral circuit structure, that is, the plurality of lower circuits PC_1, PC_2, PC_3, and CAP_C.

The conductive stack region STc may include insulating layers 124 and conductive layers 126 alternately and repeatedly stacked in the vertical direction Z. The insulating layers 124 may include silicon oxide. Among the insulating layers 124 and the conductive layers 126, a lowermost layer may be the lowermost insulating layer, and an uppermost layer may be the uppermost insulating layer.

In the conductive stack region STc, the conductive layers 126 disposed in the memory blocks mBLK may be gate electrodes, and the conductive layers 126 disposed in the capacitor blocks cBLK may be capacitor electrodes.

The insulating stack region STi may include first insulating layers 120 and second insulating layers 122 alternately and repeatedly stacked in the vertical direction Z. The first insulating layers 120 may be disposed at the same level as a level of the insulating layers 124 and may include the same material as that of the insulating layers 124. The second insulating layers 122 may be disposed at the same level as a level of the conductive layers 126 and may include a material different from that of the first insulating layers 120. For example, the first insulating layers 120 may include silicon oxide, and the second insulating layers 122 may include silicon nitride.

The separation structure SP described with reference to FIG. 2 may penetrate through the conductive stack region STc in the vertical direction Z. The plurality of blocks mBLK, dBLK, cBLK, and STe may be spaced apart from each other by the separation structure SP. Accordingly, the separation structure SP may separate the plurality of blocks mBLK, dBLK, cBLK, and STe.

At least one block among the plurality of blocks mBLK, dBLK, cBLK, and STe may have a side surface surrounded by the separation structure SP. For example, each of the plurality of blocks mBLK, dBLK, cBLK, and STe may have a side surface surrounded by the separation structure SP. Accordingly, the plurality of blocks mBLK, dBLK, cBLK, and STe may be limited by the separation structure SP.

The second chip structure CH_U may further include a plurality of vertical structures VSm, VSmd1, VSmd2, VScd, VSdd, VSde, and VSdi penetrating through the stack structure ST.

The plurality of vertical structures VS may include vertical memory structures VSm penetrating through the memory regions MA of the memory blocks mBLK, vertical support structures VSmd2 disposed between the vertical memory structures VSm and penetrating through the memory regions MA of the memory blocks mBLK, vertical support structures VSmd1 penetrating through the connection regions CA of the memory blocks mBLK, vertical support structures VSdd penetrating through the at least one dummy block dBLK, vertical support structures VScd penetrating through the plurality of capacitor blocks cBLK, vertical support structures VSde penetrating through the edge block STe, and vertical support structures VSdi penetrating through the insulating stack region STi.

In the diagram viewed from above (e.g. FIG. 4B), each of the vertical memory structures VSm may include a channel layer 108 having a ring shape, a data storage structure 106 surrounding an external side surface of the channel layer 108, and a pad layer 112 in contact with the channel layer 108. The channel layer 108 may include a semiconductor material such as silicon. The pad layer 112 may include at least one of doped polysilicon, metal nitride (e.g., TiN, or the like), metal (e.g., W, or the like), and metal-semiconductor compound (e.g., TiSi, or the like). The data storage structure 106 may include a first dielectric layer 106c, a second dielectric layer 106a, and a data storage layer 106b between the first dielectric layer 106c and the second dielectric layer 106a. The first dielectric layer 106c may include silicon oxide or silicon oxide doped with impurities. The second dielectric layer 106a may include at least one of silicon oxide and a high-x material. A high-κ material may be a material having a dielectric constant that is higher than that of silicon oxide. The data storage layer 106b may include a material which may be configured to store data by trapping charges, for example, silicon nitride. The data storage layer 106b may include regions which may store data in a semiconductor device such as a flash memory device.

In an example embodiment, the data storage structure 106 may include the data storage layer 106b which is configured to store data by trapping charges, but an example embodiment thereof is not limited thereto. For example, the data storage structure 106 may be configured as a data storage structure used in a ferroelectric memory which may be configured to store data using remnant polarization by dipoles.

The second chip structure CH_U may further include separation patterns 103 penetrating through one of the conductive layers 126 or the plurality of lower conductive layers in the plurality of memory blocks mBLK. In FIG. 4B, in the diagram viewed from above, a separation pattern 103 may be disposed between the first horizontal portions SP_H of a pair of separation structures SP adjacent to each other in the second direction Y, the vertical memory structures VSm may be disposed between the first horizontal portions SP_H and the separation pattern 103, and the vertical support structures VSmd2 may be disposed in an intermediate region between the first horizontal portions SP_H. The separation patterns 103 may vertically overlap the vertical support structures VSmd2. Each of the vertical memory structures VSm may vertically overlap two bit lines BL among the bit lines BL, and may be electrically connected to one bit line of the two vertically overlapping the bit lines BL.

The second chip structure CH_U may further include an upper interconnection structure 140 disposed below the stack structure ST, upper bonding pads 148 below the upper interconnection structure 140, and the upper insulating structure 150 covering the upper interconnection structure 140 and covering the side surface of the upper bonding pads 148 below the stack structure ST.

The upper interconnection structure 140 may include a plurality of upper horizontal portions 142 disposed on different levels, and a plurality of upper vertical portions 144 disposed on different levels.

Each of the plurality of upper horizontal portions 142 may be an upper interconnection line or an upper pad. For example, the plurality of upper horizontal portions 142 may be referred to as upper interconnections or upper pads. The plurality of upper vertical portions 144 may be referred to as upper vias or upper contact plugs.

The plurality of upper horizontal portions 142 may include first upper horizontal portions 142a, second upper horizontal portions 142b below the first upper horizontal portions 142a, and third upper horizontal portions 142c below the second upper horizontal portions 142b.

The plurality of upper vertical portions 144 may include first upper vertical portions 144a of the first upper horizontal portions 142a, second upper vertical portions 144b between the first upper horizontal portions 142a and the second upper horizontal portions 142b, third upper vertical portions 144c between the second upper horizontal portions 142b and the third upper horizontal portions 142c, and fourth upper vertical portions 144d below the third upper horizontal portions 142c.

The upper bonding pads 148 may be electrically connected to the upper interconnection structure 140 below the upper interconnection structure 140.

The upper insulating structure 150 may cover the upper interconnection structure 140 below the stack structure ST and may cover side surfaces of the upper bonding pads 148. The lower surface of the upper insulating structure 150 may be coplanar with the lower surfaces of the upper bonding pads 148.

The lower surface of the upper insulating structure 150 may be in contact with and bonded to the upper surface of the lower insulating structure 220.

The lower surfaces of the upper bonding pads 148 may be in contact with and bonded to the upper surfaces of the lower bonding pads 214. The upper bonding pads 148 may include the same metal material as that of the lower bonding pads 214. For example, the upper bonding pads 148 and the lower bonding pads 214 may include copper.

The second chip structure CH_U may further include an upper plate pattern 160c and pad patterns 160p on the stack structure ST, an insulating layer 170 on the side surfaces of the upper plate pattern 160c and a capping insulating layer 174 on the plate pattern 160c, the pad pattern 160p and the insulating layer 170.

The upper plate pattern 160c may include a portion disposed on the conductive stack region STc and a portion disposed on the insulating stack region STi. The upper plate pattern 160c may be connected to the vertical memory structures VSm of the plurality of memory blocks mBLK.

Each of the upper plate pattern 160c and the pad patterns 160p may include a first layer 162 and a second layer 164 on the first layer 162. The first layer 162 may be a polysilicon layer having an N-type conductivity type, and the second layer 164 may be a conductive layer including at least one of a metal-semiconductor compound, metal nitride, and metal.

Among the upper plate pattern 160c, a portion connected to the vertical memory structures VSm, for example, the first layer 162, may be configured as a common source or a common source region.

The insulating layer 170 may include an insulating material such as silicon oxide, a low-x material, or silicon nitride. A low-x material may be a material having a dielectric constant that is less than that of silicon oxide.

The second chip structure CH_U may further include the input/output pads IOP described above with reference to FIGS. 1A, 1B, 1D, and 2. The input/output pads IOP may penetrate through at least a portion of the capping insulating layer 174. The input/output pads IOP may be connected to the pad patterns 160p.

The second chip structure CH_U may further include contact plugs CPc1, CPc2, CPio and insulating spacers 132 surrounding side surfaces of the contact plugs CPc1, CPc2, and CPio.

The contact plugs CPg, CPc1, CPc2, and CPio may include gate contact plugs CPg, capacitor contact plugs CPc1, CPc2, and input/output contact plugs CPio.

The gate contact plugs CPg may be electrically connected to the conductive layers 126, that is, the gate electrodes, disposed in the connection region CA in the memory blocks mBLK.

The gate contact plugs CPg may extend in the vertical direction Z toward the conductive stack structure STc to different lengths to be in contact with the conductive layers 126 disposed on different levels within the conductive stack structure STc. For example, when viewed with respect to the cross-sectional structure as illustrated in FIG. 7A, the gate contact plugs CPg may have lower surfaces disposed at the same level below the memory blocks mBLK, and may extend at different lengths to be in contact with the conductive layers 126 disposed on different levels from those of the lower surfaces, and upper surfaces of the gate contact plugs CPg in contact with the conductive layers 126 disposed on different levels may be disposed on different levels.

The capacitor contact plugs CPc1 and CPc2 may be electrically connected to the conductive layers 126, that is, capacitor electrodes, disposed in the capacitor blocks cBLK.

The capacitor contact plugs CPc1 and CPc2 may extend in the vertical direction Z toward the conductive stack structure STc to different lengths to be in contact with the conductive layers 126 disposed on different levels within the conductive stack structure STc. For example, when viewed with respect to the cross-sectional structure as illustrated in FIGS. 7B and 7C, the capacitor contact plugs CPc1 and CPc2 may have lower surfaces disposed at the same level below the capacitor blocks cBLK, may extend at different lengths to be in contact with the conductive layers 126 disposed on different levels from the lower surfaces, and upper surfaces of the capacitor contact plugs CPc1 and CPc2, in contact with the conductive layers 126 disposed on different levels, may be disposed on different levels.

The capacitor contact plugs CPc1 and CPc2 may include capacitor contact plugs CPc1 electrically connected to the first capacitor electrodes of the capacitor blocks cBLK and capacitor contact plugs CPc2 electrically connected to the second capacitor electrodes of the capacitor blocks cBLK.

In the description below, for ease of description, the first capacitor block cBLK1 and the second capacitor block cBLK2 among the capacitor blocks cBLK will be mainly described.

The capacitor contact plugs CPc1 and CPc2 may include first capacitor contact plugs CPc1a connected to the conductive layers forming the first capacitor electrode among the conductive layers 126 of the first capacitor block cBLK1, second capacitor contact plugs CPc2a connected to the conductive layers forming the second capacitor electrode among the conductive layers 126 of the first capacitor block cBLK1, third capacitor contact plugs CPc1b connected to the conductive layers forming the first capacitor electrode among the conductive layers 126 of the second capacitor block cBLK2, and fourth capacitor contact plugs CPc2b connected to the conductive layers forming the second capacitor electrode among the conductive layers 126 of the second capacitor block cBLK2.

Among the conductive layers 126 of each of the capacitor blocks cBLK, when odd-numbered conductive layers are included in the first capacitor electrode, the first capacitor contact plugs CPc1 may be connected to the odd-numbered conductive layers, and when even-numbered conductive layers are included in a second capacitor electrode, the second capacitor contact plugs CPc2 may be connected to even-numbered conductive layers. In an example embodiment, odd-numbered layers and even-numbered layers may be defined on the basis of the lowermost conductive layer among the conductive layers 126 stacked in the vertical direction Z.

In an example embodiment, the example in which odd-numbered conductive layers form the first capacitor electrode and even-numbered conductive layers form the second capacitor electrode among the conductive layers 126 of each of the capacitor blocks cBLK is described, but an example embodiment thereof is not limited thereto. In an example, among the conductive layers 126 of each of the capacitor blocks cBLK, among a pair of conductive layers adjacent to each other in the vertical direction Z, a pair of odd-numbered conductive layers may form the first capacitor electrode, and a pair of even-numbered conductive layers disposed may form a second capacitor electrode.

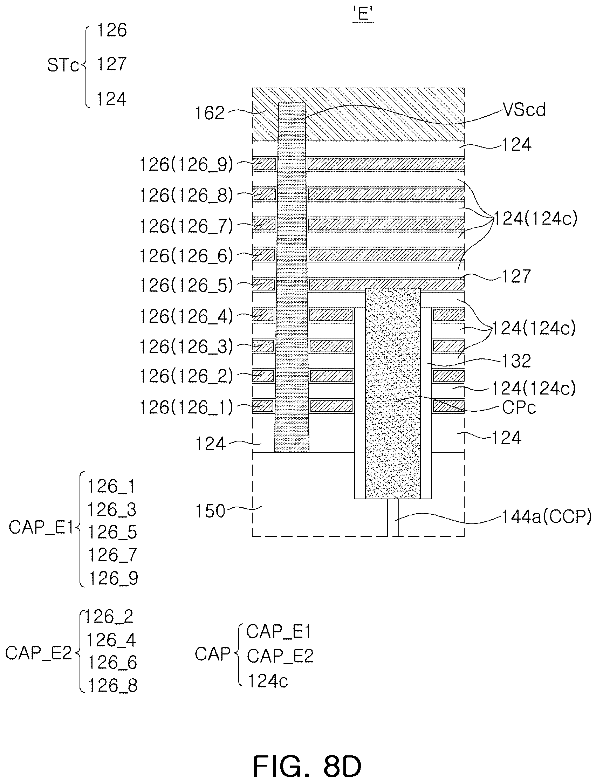

In example embodiments, each of the capacitors in the capacitor blocks cBLK may include capacitor electrodes and a dielectric between the capacitor electrodes, and a capacitor (CAP in FIG. 8D) including capacitor electrodes (CAP_E1, CAP_E2 in FIG. 8D) and capacitor dielectric (124c in FIG. 8D) may be understood from FIG. 8D, which will be described later. An example embodiment of the capacitor including the capacitor electrodes and the capacitor dielectric will be described later with reference to FIGS. 8A to 8D.

The input/output contact plugs CPio may penetrate through the insulating stack region STi.

The upper interconnection structure 140, the lower interconnection structure 208, the lower bonding pads 214, and the upper bonding pads 148 may be included in a routing interconnection structure RWS.

The input/output contact plugs CPio may include a first input/output contact plug CPio1 electrically connected to the first input/output pad IOP1. The first capacitor electrode of the first capacitor in the first capacitor block cBLK1 may be electrically connected to the first input/output pad IOP1 through the first input/output contact plug CPio1 and the routing interconnection structure RWS, and the second capacitor electrode may be grounded to the ground region GND of the first chip structure CH_L through the routing interconnection structure RWS. The first capacitor in the first capacitor block cBLK1 may act as a damper when the input/output speed (IO speed) increases through the first input/output pad IOP1.

The second chip structure CH_U may include a portion of the horizontal portions 142a, 142b, and 142c of the upper interconnection structure 140, for example, bit lines BL, which may include the first upper horizontal portion 142a, and bit line contact plugs BCP, which may include the first upper vertical portion 144a among the vertical portions 144a, 144b, 144c, and 144d of the upper interconnection structure 140.

Each of the bit lines BL may extend in the second direction Y, and the bit lines BL may be spaced apart from each other in the first direction X. The bit lines BL may be electrically connected to the vertical memory structures VSm.

The bit line contact plugs BCP may be disposed between the bit lines BL and the vertical memory structures VSm, and may electrically connect the bit lines BL to the vertical memory structures VSm.

The second chip structure CH_U may include first capacitor electrode interconnection CW1a, second capacitor electrode interconnection CW2a, third capacitor electrode interconnection CW1b, and fourth capacitor electrode interconnection CW2b, which may include at least a portion of the routing interconnection structure RWS. For example, the first to fourth capacitor electrode interconnections CW1a, CW2a, CW1b, and CW2b may include a portion of the horizontal portions 142a, 142b, and 142c of the upper interconnection structure 140, for example, first upper horizontal portion 142a.

The first capacitor electrode interconnection CW1a may be electrically connected to the first capacitor contact plugs CPcla, and the second capacitor electrode interconnection CW2a may be electrically connected to the second capacitor contact plugs CPc2a.

The third capacitor electrode interconnection CW1b may be electrically connected to the third capacitor contact plugs CPc1b, and the fourth capacitor electrode interconnection CW2b may be electrically connected to the fourth capacitor contact plugs CPc2b.

The input/output contact plugs CPio may be electrically connected to transistors PTRio electrically connected to the input/output pads IOP among the peripheral transistors PTR through the routing interconnection structure RW. The input/output contact plugs CPio may include a first input/output contact plug CPio1 electrically connected to the first input/output pad IOP1 and a second input/output contact plug CPio2 electrically connected to the second input/output pad IOP2. The first input/output pad IOP1 may be electrically connected to the first peripheral transistor PTRio1 through the first input/output contact plug CPio1 and the routing interconnection structure RWS. The second input/output pad IOP2 may be electrically connected to the second peripheral transistor PTRio2 through the second input/output contact plug CPio2 and the routing interconnection structure RWS.

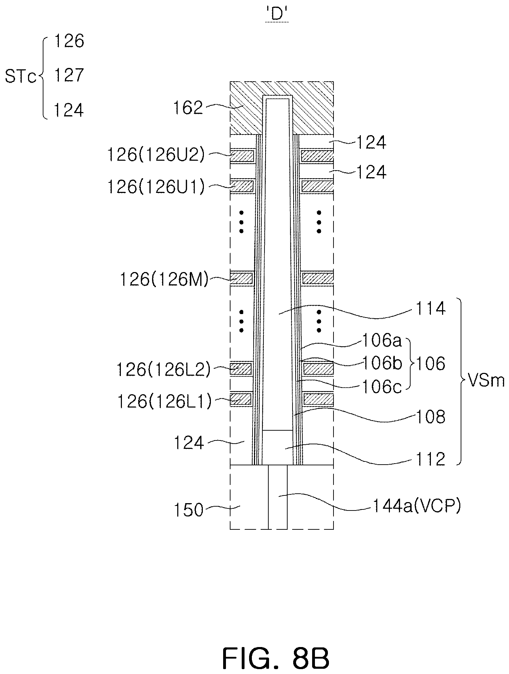

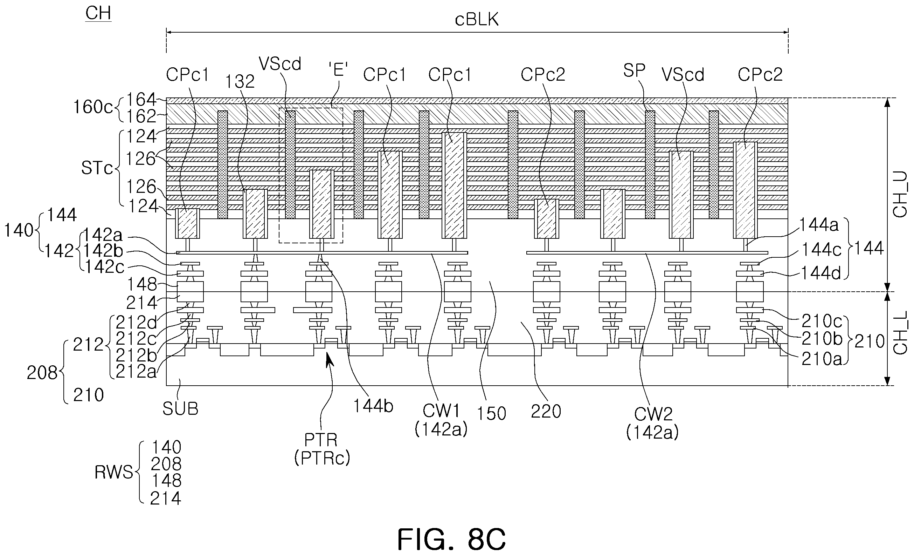

In the description below, the electrical connection relationship of the elements of the semiconductor device CH illustrated in FIGS. 1A to 7C will be described with reference to FIGS. 8A, 8B, 8C and 8D. FIG. 8A illustrates the electrical connection relationship between the conductive layers 126 in the memory blocks mBLK among the elements of the semiconductor device CH described with reference to FIGS. 1A to 7C, the electrical connection relationship between the vertical memory structures VSm, and the electrical connection relationship between the upper plate pattern 160c, which may include a common source, FIG. 8B is an enlarged diagram illustrating a portion of region "D" in FIG. 8A, FIG. 8C is a cross-sectional diagram illustrating the electrical connection relationship between the conductive layers 126 in the capacitor blocks cBLK among the elements of the semiconductor device CH described in FIGS. 1A to 7C, and FIG. 8D is an enlarged diagram illustrating region "E" in FIG. 8C.

Referring to FIGS. 1A to 7C and FIGS. 8A to 8D, as described above, the routing interconnection structure RWS may include the upper interconnection structure 140, the lower interconnection structure 208, the lower bonding pads 214, and the upper bonding pads 148.

The vertical memory structures VSm may be electrically connected to the first peripheral transistor PTRb among the peripheral transistors PTR through the routing interconnection structure RWS. The bit line BL described above may be electrically connected to the vertical memory structures VSm and may be configured as a portion of the routing interconnection structure RWS, for example, the first upper horizontal portions 142a.

The first peripheral transistor PTRb may be configured as a transistor that are included in the page buffer (95 in FIG. 1D) in the peripheral circuit (PC in FIG. 1C) described above.

In the memory blocks mBLK, the conductive layers 126 may include lower conductive layers 126L1 and 126L2, upper conductive layers 126U1 and 126U2, and intermediate conductive layers 126M between the lower conductive layers 126L1 and 126L2 and the upper conductive layers 126U1 and 126U2. The lower conductive layers 126L1 and 126L2 may include a first lower conductive layer 126L1 and a second lower conductive layer 126L2 on the first lower conductive layer 126L1. The upper conductive layers 126U1 and 126U2 may include a first upper conductive layer 126U1 and a second upper conductive layer 126U2 on the first upper conductive layer 126U1.

The first lower conductive layer 126L1 and the second upper conductive layer 126U2 may be the erase control lines (ECL in FIG. 1D) described with reference to FIG. 1D.

The second lower conductive layer 126L2 may be the string selection line SSL described with reference to FIG. 1D.

The intermediate conductive layers 126M may be the word lines (WL in FIG. 1D) described with reference to FIG. 1D.

The first upper conductive layer 126U1 may be the ground selection lines GSL described with reference to FIG. 1D.

The gate contact plugs CPg, which are electrically connected to the conductive layers 126 in the memory blocks mBLK, may be electrically connected to second transistors PTRg among the peripheral transistors PTR through the routing interconnection structure RWS.

Accordingly, the conductive layers 126 which may form the erase control lines (ECL in FIG. 1D), the string selection line SSL, the word lines (WL in FIG. 1D), and the ground selection lines GSL described with reference to FIG. 1D may be electrically connected to the second transistors PTRg through the gate contact plugs CPg and the routing interconnection structure RWS.

The upper plate pattern 160c may be electrically connected to the third transistor PTRs among the peripheral transistors PTRs through the source contact plug CPs penetrating through the insulating stack region STi and the routing interconnection structure RWS.

The first layer 162 of the upper plate pattern 160c may be the common source (CSL in FIG. 1D) described with reference to FIG. 1D. Accordingly, the first layer 162 of the upper plate pattern 160c may be electrically connected to the third transistor PTRs through the source contact plug CPs and the routing interconnection structure RWS.

The second transistors PTRg and the third transistor PTRs may be transistors included in the address decoder 93.

Each of the capacitor blocks cBLK may include the capacitor CAP described with reference to FIG. 1D. Here, since FIG. 8C is a cross-sectional diagram mainly illustrating one capacitor block cBLK among the capacitor blocks cBLK, the capacitor block cBLK will be mainly described.

In the capacitor block cBLK, the conductive layers 126 may include a first lower conductive layer 126_1, a second lower conductive layer 126_2, a third lower conductive layer 126_3, a fourth lower conductive layer 126_4, a fifth lower conductive layer 126_5, a sixth lower conductive layer 126_6, a seventh lower conductive layer 126_7, an eighth lower conductive layer 126_8, and a ninth lower conductive layer 126_9, stacked in order. In the drawing, nine conductive layers 126 are illustrated as an example embodiment, but in an example embodiment, the number of conductive layers 126 may be different (e.g. more than 9).

The capacitor CAP in the capacitor block cBLK may include a first capacitor electrode CAP_E1, a second capacitor electrode CAP_E2, and capacitor dielectric layers 124c.

In the capacitor block cBLK, the first capacitor electrode CAP_E1 may include odd-numbered conductive layers 126_1, 126_3, 126_5, 126_7, and 126_9 among the conductive layers 126, and the second capacitor electrode CAP_E2 may include even-numbered conductive layers 126_2, 126_4, 126_6, and 126_8 among the conductive layers 126. In this case, the capacitor dielectric layers 124c may be insulating layers disposed between the odd-numbered conductive layers 126_1, 126_3, 126_5, 126_7, 126_9 and the even-numbered conductive layers 126_2, 126_4, 126_6, and 126_8 among the insulating layers 124.

In an example embodiment, odd-numbered and even-numbered may be defined with respect to the lowermost conductive layer among the conductive layers 126 stacked in the vertical direction Z.

In an example embodiment, the example in which, among the conductive layers 126 of each of the capacitor blocks cBLK, the odd-numbered conductive layers 126_1, 126_3, 126_5, 126_7, and 126_9 may be included in the first capacitor electrode CAP_E1, and the even-numbered conductive layers 126_2, 126_4, 126_6, and 126_8 are included in the second capacitor electrode CAP_E2 is described, but an example embodiment thereof is not limited thereto.

For example, among the conductive layers 126 of each of the capacitor blocks cBLK, a plurality of conductive layers included in the first capacitor electrode CAP_E1 and adjacent to each other in the vertical direction, and another pair of conductive layers included in the second capacitor electrode CAP_E2 and adjacent to each other in the vertical direction may be alternately arranged in the vertical direction. For example, the first and second conductive layers 126_1, 126_2, and the fifth and sixth conductive layers 126_5, 126_6 adjacent to each other may be included in the first capacitor electrode CAP_E1, and the third and fourth conductive layers 126_3, 126_4 adjacent to each other and the seventh and eighth conductive layers 126_7, 126_8 adjacent to each other may be included in the second capacitor electrode CAP_E2. Here, the ninth conductive layer 126_9 may be an electrically isolated dummy layer.

In the description below, for ease of description, the example in which, among the conductive layers 126 of each of the capacitor blocks cBLK, the odd-numbered conductive layers 126_1, 126_3, 126_5, 126_7, and 126_9 may be included in the first capacitor electrode CAP_E1, and the even-numbered conductive layers 126_2, 126_4, 126_6, and 126_8 may be included in the second capacitor electrode CAP_E2 will be described.

The conductive layers 126 of each of the capacitor blocks cBLK may be electrically connected to the capacitor contact plugs CPc.

The capacitor contact plugs CPc may include first capacitor contact plugs CPc 1 connected to the odd-numbered conductive layers 126_1, 126_3, 126_5, 126_7, 126_9 forming the first capacitor electrode CAP_E1, and second capacitor contact plugs CPc2 connected to the even-numbered conductive layers 126_2, 126_4, 126_6, and 126_8 included in the second capacitor electrode CAP_E2.

The first capacitor contact plugs CPc1 may be electrically connected to each other by first capacitor electrode interconnection CW 1, and the second capacitor contact plugs CPc2 may be electrically connected to each other by second capacitor electrode interconnection CW2.

A conductive via CCP including the first upper vertical portion 144a of the upper vertical portions of the upper interconnection structure 140 of the routing interconnection structure RWS may be disposed between the first and second capacitor contact plugs CPc1 and CPc2 and the first and second capacitor electrode interconnections CW1 and CW2. Here, the conductive via CCP may also be referred to as a contact plug or conductive stud.

The insulating spacers 132 covering the side surfaces of the capacitor contact plugs CPc may be disposed on a level lower than a level of the conductive layer in contact with the capacitor contact plugs CPc. For example, the capacitor contact plug CPc illustrated in FIG. 8D may be electrically connected to the fifth conductive layer 126_5, the insulating spacer 132 may be disposed on a level lower than a level of the fifth conductive layer 126_5, and may separate the first to fourth conductive layers 126_1, 126_2, 126_3, 126_4, which are disposed on a level lower than a level of the fifth conductive layer 126_5, and the capacitor contact plug CPc from each other. The capacitor contact plug CPc may protrude beyond a top of the insulating spacer 132. Accordingly, the capacitor contact plugs CPc may be electrically connected to the conductive layers in a desired position by the insulating spacers 132.

The first and second capacitor electrode interconnections CW1 and CW2 may be configured as a portion of the routing interconnection structure RWS. For example, the first and second capacitor electrode interconnections CW 1 and CW2 may include a portion of the horizontal portions 142a, 142b, and 142c of the upper interconnection structure 140 of the routing interconnection structure RWS, for example, the first upper horizontal portion 142a.

At least one of the first and second capacitor electrode interconnections CW 1 and CW2 may be electrically connected to a circuit PTRc through the routing interconnection structure RWS.

The circuit PTRc electrically connected to the capacitor CAP through the first and second capacitor electrode interconnections CW1, CW2 and the routing interconnection structure RWS may include a transistor or a PN diode. For example, in FIG. 8C, a portion of the circuit PTRc electrically connected to the first capacitor electrode CAP_E1 of the capacitor CAP is illustrated as a transistor, but in example embodiments, a portion of the circuit PTRc electrically connected to the first capacitor electrode CAP_E1 may be a PN diode.

The conductive stack region STc may further include a dielectric layer 127 covering the upper and lower surfaces of each of the conductive layers 126 and at least a portion of each of the side surfaces of the conductive layers 126. For example, the dielectric layers 127 may cover the upper surfaces and lower surfaces of the conductive layers 126, may extend to a region between the side surfaces of the conductive layers 126 and the side surfaces of the vertical structures VSm, VSmd1, VSmd2, VScd, VSdd, and VSde penetrating through the conductive stack region STc, and may extend to a region between the insulating spacers 132 and the side surfaces of the conductive layers 126 horizontally adjacent to the insulating spacers 132. The contact plugs CPg and CPc may penetrate through the dielectric layers 127 covering the lower surfaces of the conductive layers 126 and may be in contact with the conductive layers 126.

Various modified examples of elements of the example embodiment described above will be described. Various modified examples of the elements of the above-mentioned example embodiment described below will be described focusing on modified or replaced elements. Here, the elements described above may be quoted directly without detailed description, or the description may not be provided. Also, the elements which may be modified or replaced described below will be described with reference to the drawings, and the elements may be combined with each other or with the elements described above to form a semiconductor device according to an example embodiment.

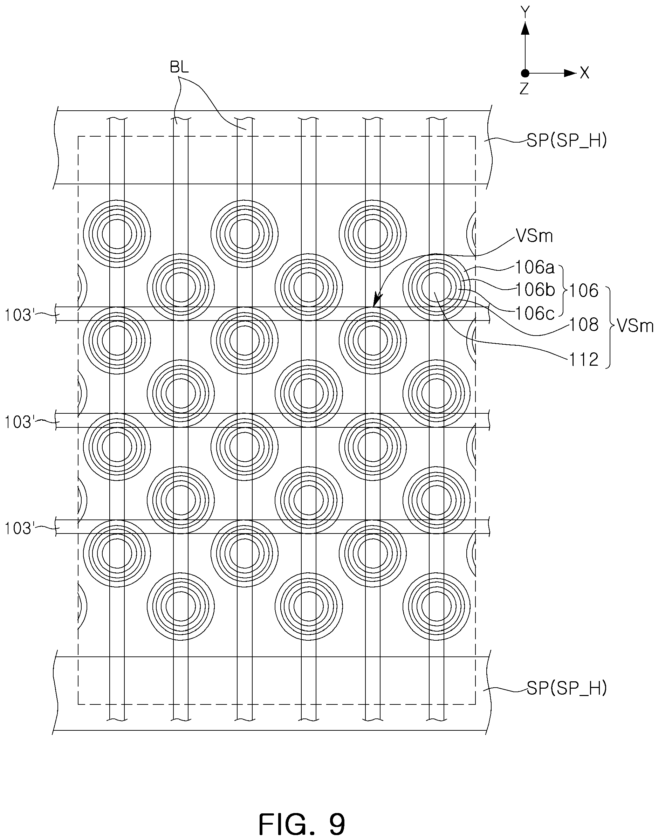

In the description below, an example in which the arrangement shape of elements in the diagram in FIG. 4B is modified will be described with reference to FIG. 9. FIG. 9 is a diagram illustrating an example in which the arrangement shape of elements in the diagram viewed from above in FIG. 4B is modified.

Referring to FIG. 9, the plurality of separation patterns 103 may be disposed between the first horizontal portions SP_H of a pair of separation structures SP adjacent to each other in the second direction Y. The vertical memory structures VSm may be arranged in a zigzag form in the first direction X, and may be arranged while being spaced apart from each other in the second direction Y. The distance between centers of the bit lines BL may be substantially the same as the distance between centers of the vertical memory structures VSm arranged in a zigzag form in the first direction X. Accordingly, each of the vertical memory structures VSm zigzagly arranged in the first direction X may be electrically connected while vertically overlapping one bit line of the bit lines BL.

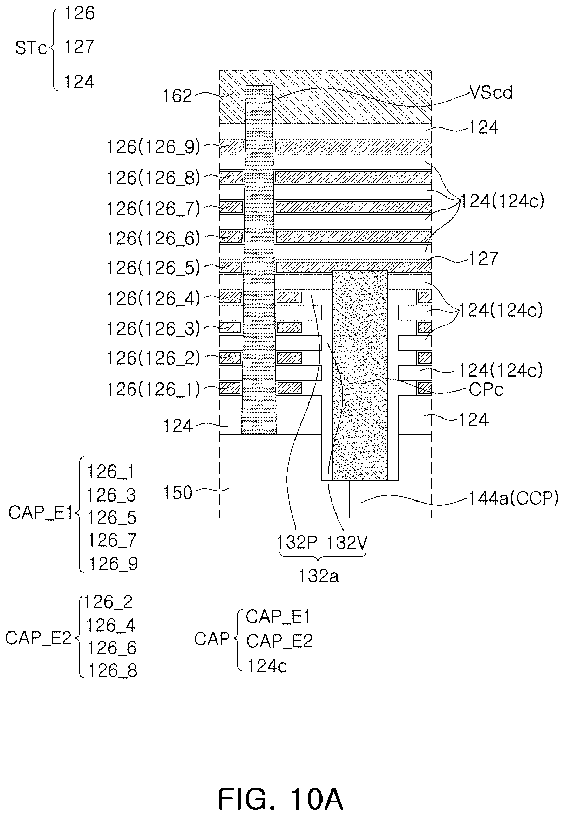

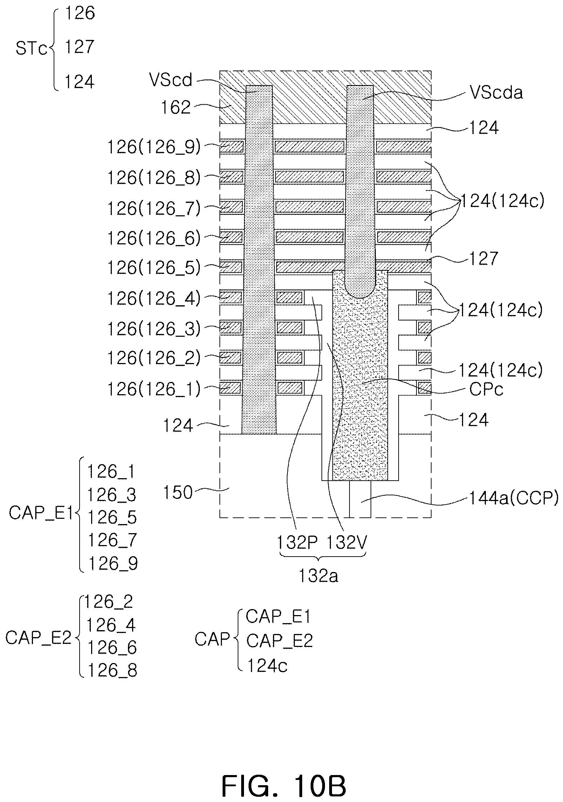

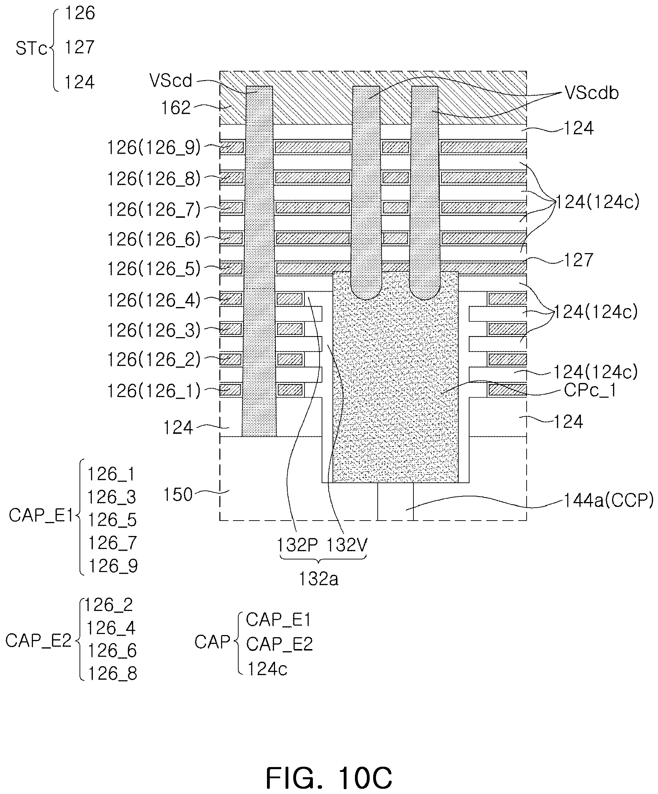

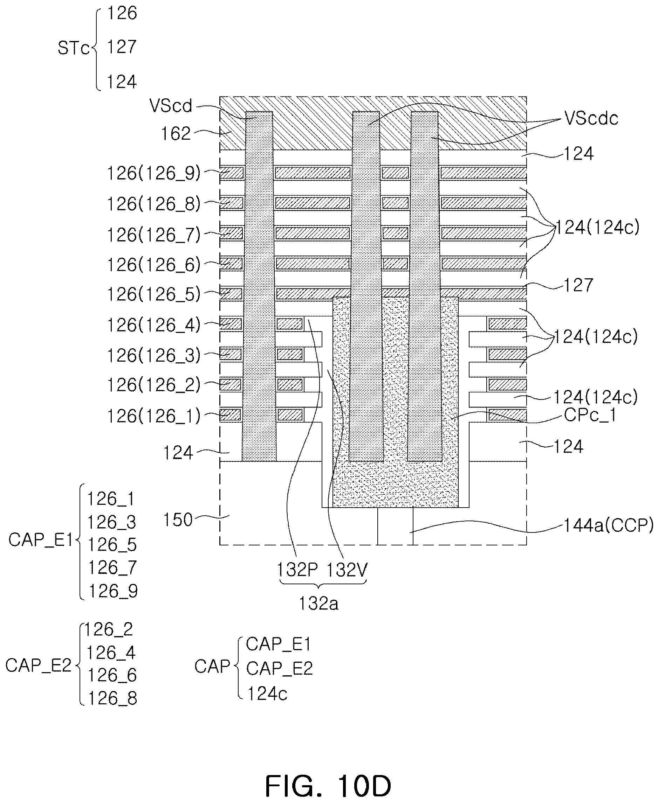

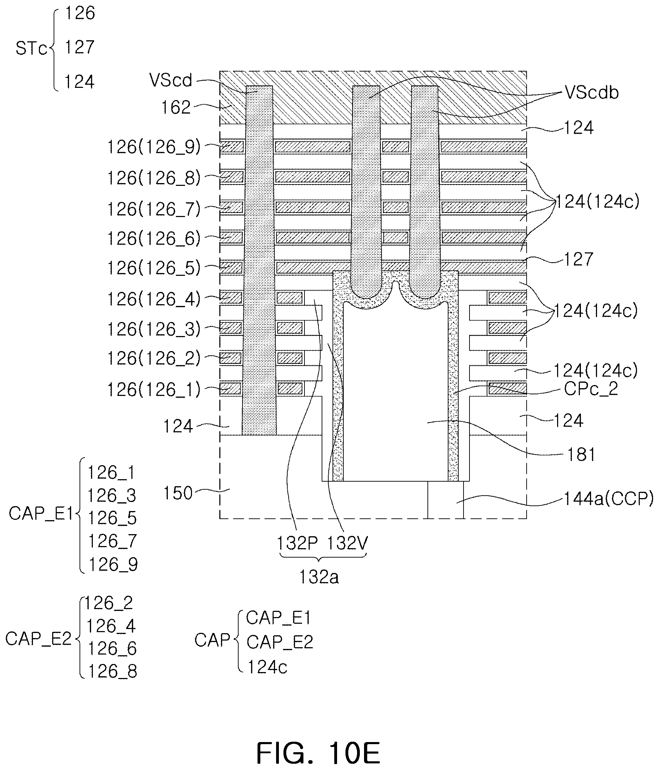

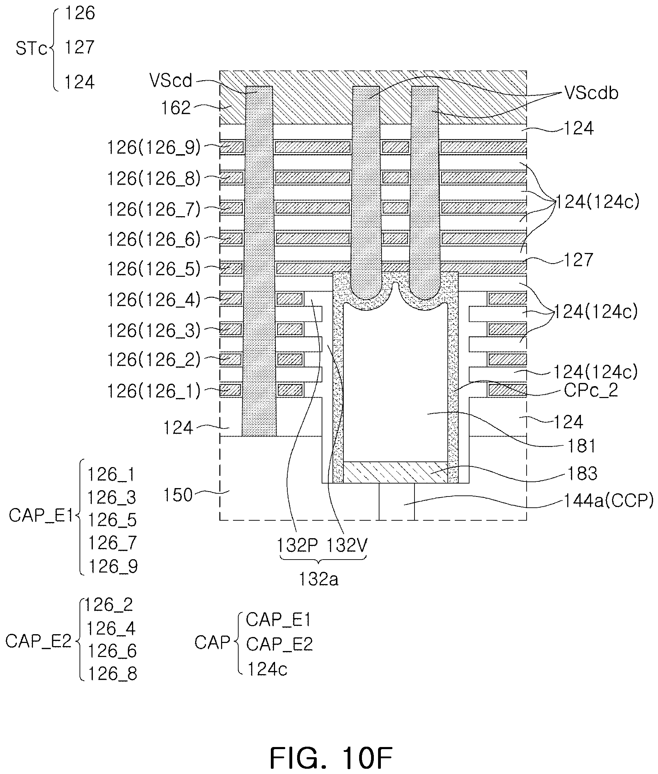

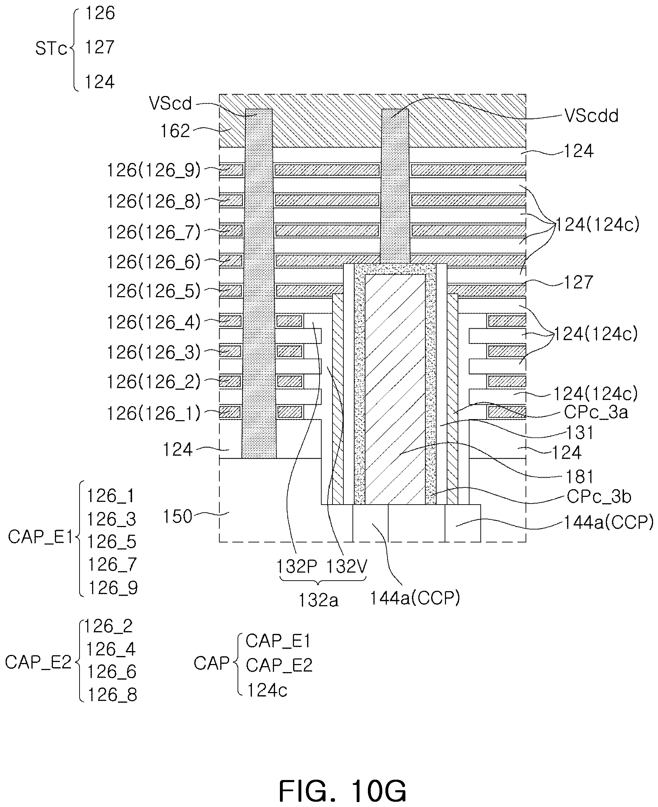

In the description below, various modified examples of a semiconductor device according to an example embodiment will be described with reference to FIGS. 10A, 10B, 10C, 10D, 10E, 10F, and 10G. FIGS. 10A, 10B, 10C, 10D, 10E, 10F, and 10G are enlarged cross-sectional diagrams illustrating a modified example of the enlarged cross-sectional diagram in FIG. 8D. In the description below, one contact plug among the capacitor contact plugs CPc will be mainly described. In the description below, the contact plug described may be one of the capacitor contact plugs CPc, but in example embodiments, the contact plug may also be one of the gate contact plugs CPg.

In a modified example, referring to FIG. 10A, the insulating spacer (132 in FIG. 8D) described above may include a vertical portion 132V covering a side surface of the contact plug CPc and protrusion portions 132P extending to a region between the insulating layers 124 adjacent to the vertical portion 132V.

In a modified example, referring to FIG. 10B, the vertical support structures VScd described above may include a first vertical support structure VScda in contact with an upper region of the contact plug CPc and penetrating through the conductive layers 126 and the insulating layers 124 disposed on a level higher than a level of the contact plug CPc. The first vertical support structure VScda may penetrate through the conductive layer 126_5 in contact with the contact plug CPc and may be in contact with the contact plug CPc.

FIG. 10B illustrates the insulating spacer 132a as in FIG. 10A, but the insulating spacer 132a may be replaced with the insulating spacer 132 as in FIG. 8D. In the drawings, when an element which may be modified or replaced described above is illustrated, the element may be understood from the modified example described above even though there is no description thereof.

In a modified example, referring to FIG. 10C, FIG. 10B illustrates one contact plug CPc in contact with one first vertical support structure VScda, but an example embodiment thereof is not limited thereto. For example, a single contact plug CPc may be modified to be in contact with plug CPc_1, which is in contact with the plurality of first vertical support structures VScdb. Each of the plurality of first vertical support structures VScdb may be substantially the same as the first vertical support structure VScda described with reference to FIG. 10B.

In a modified example, referring to FIG. 10D, the first vertical support structures (VScdb in FIG. 10C) described above may be modified to first vertical support structures VScdc extending downwardly from the upper region of the contact plug CPc_1 to a level lower than a level of the first conductive layer 126_1.

In a modified example, referring to FIG. 10E, the contact plug (CPc_1 in FIG. 10C) described above may be replaced with a contact plug CPc_2 having a shape covering a side surface and an upper surface of the insulating pillar 181. The contact plug CPc_2 may have a shape covering a lower surface of the first vertical support structures VScdb.

In the modified example, referring to FIG. 10F, the contact plug CPc_2 described above may be in contact with the conductive pad 183 covering the lower surface of the insulating pillar 181 described above. The conductive pad 183 may be disposed on a level lower than a level of the first conductive layer 126_1 and may be electrically connected to the conductive via CCP described above.

In a modified example, referring to FIG. 10G, the contact plug (CPc in FIG. 10B) described above may be replaced with an insulating pillar 181, a first contact plug CPc_3b covering the side surface and upper surface of the insulating pillar 181 and in contact with the desired conductive layer 126 6, an insulating spacer 131 covering the external side surface of the first contact plug CPc_3b, and a second contact plug CPc_3a disposed on the external side surface of the insulating spacer 131 and in contact with the conductive layer 126_5 disposed immediately below the conductive layer 126_6 in contact with the first contact plug CPc_3b. Accordingly, the conductive layers 126 5 and 126_6 adjacent to each other in the vertical direction may be connected to the contact structure including the first and second contact plugs CPc_3b and CPc_3a. In FIG. 10G, the first and second contact plugs CPc_3b, CPc_3a may be electrically connected to conductive vias CCP, respectively. However, in example embodiments, the first and second contact plugs CPc_3b, CPc_3a may be electrically connected to the conductive via CCP.

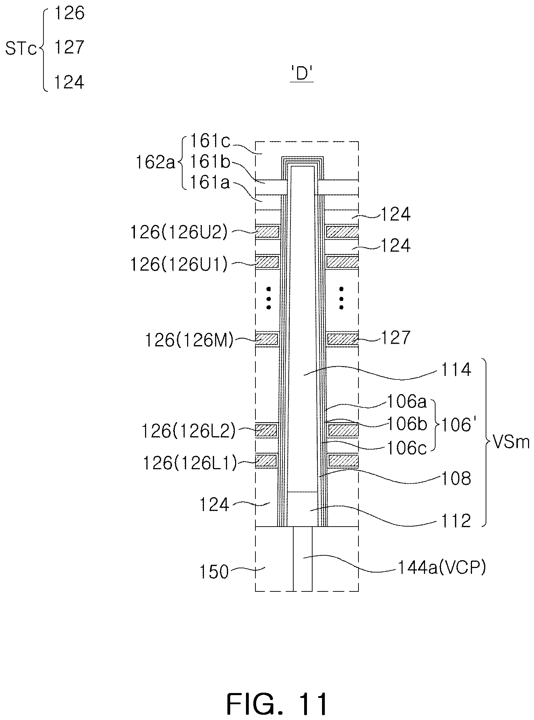

In the description below, a modified example of the previously described vertical memory structure (VSm in FIG. 8B) and the first layer (162 in FIG. 8B) of the upper plate pattern 160c will be described with reference to FIG. 11. FIG. 11 is an enlarged cross-sectional diagram illustrating a modified example of the enlarged diagram in FIG. 8B.

In a modified example, referring to FIG. 11, the first layer (162 in FIG. 8B) of the upper plate pattern 160c may include a first material layer 161a, a second material layer 161b on the first material layer 161a, and a third material layer 161c on the second material layer 161b.

In the vertical memory structure VSm, the data storage structure 106' may cover the side surface and upper surface of the channel layer 108, the first material layer 161a may cover the side surface of the data storage structure 106' on the uppermost insulating layer among the insulating layers 124, the second material layer 161b may penetrate through the data storage structure 106' and may be in contact with the channel layer 108, and the third material layer 161c may be separated from the channel layer 108 by the data storage structure 106'.

At least one of the first to third material layers 161a, 16b, and 16c may include doped silicon.

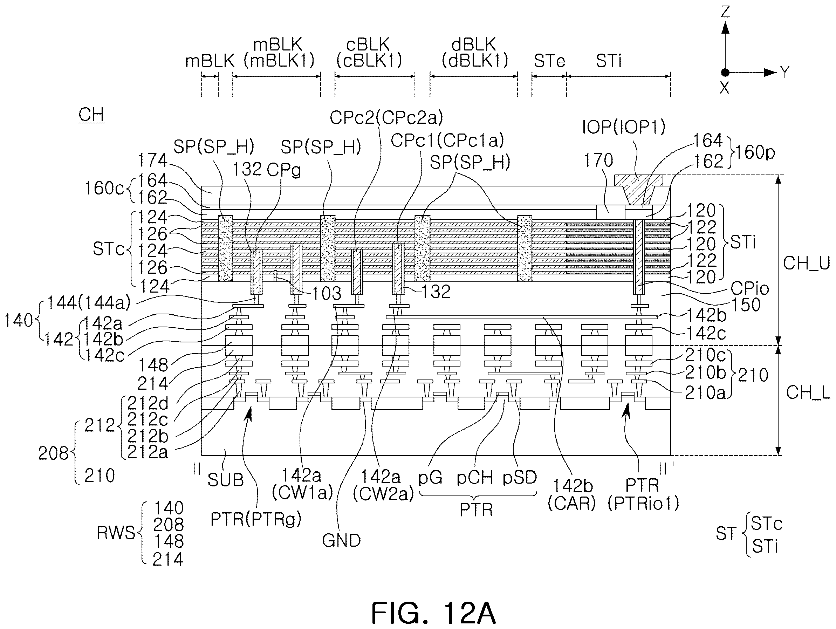

In the description below, various examples of the routing interconnection structure RWS which may be included in the capacitor routing interconnections (CAR in FIG. 6B) described above will be described with reference to FIGS. 12A to 12C. FIGS. 12A to 12C are cross-sectional diagrams illustrating various modified examples of the cross-sectional structure in FIG. 6B which illustrates the example in which the capacitor routing interconnections (CAR in FIG. 6B) may form the first upper horizontal portion 142a of the horizontal portions 142a, 142b, and 142c of the upper interconnection structure 140 among the routing interconnection structure RWS.

In a modified example, referring to FIG. 12A, the capacitor routing interconnections (CAR in FIG. 6B) may include the second horizontal portion 142b of the horizontal portions 142a, 142b, and 142c of the upper interconnection structure 140 among the routing interconnection structure RWS.

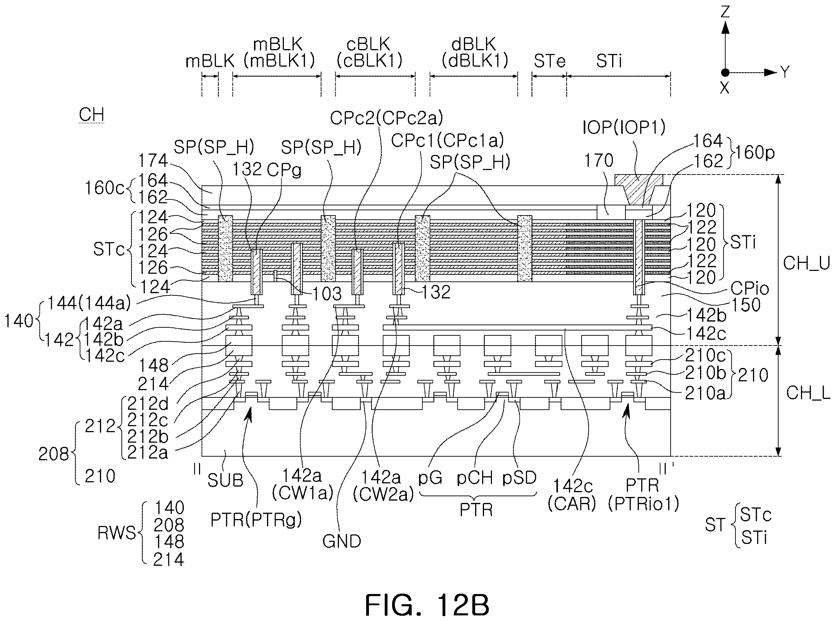

In a modified example, referring to FIG. 12B, the capacitor routing interconnections (CAR in FIG. 6B) may include the third horizontal portion 142c of the horizontal portions 142a, 142b, and 142c of the upper interconnection structure 140 among the routing interconnection structure RWS.

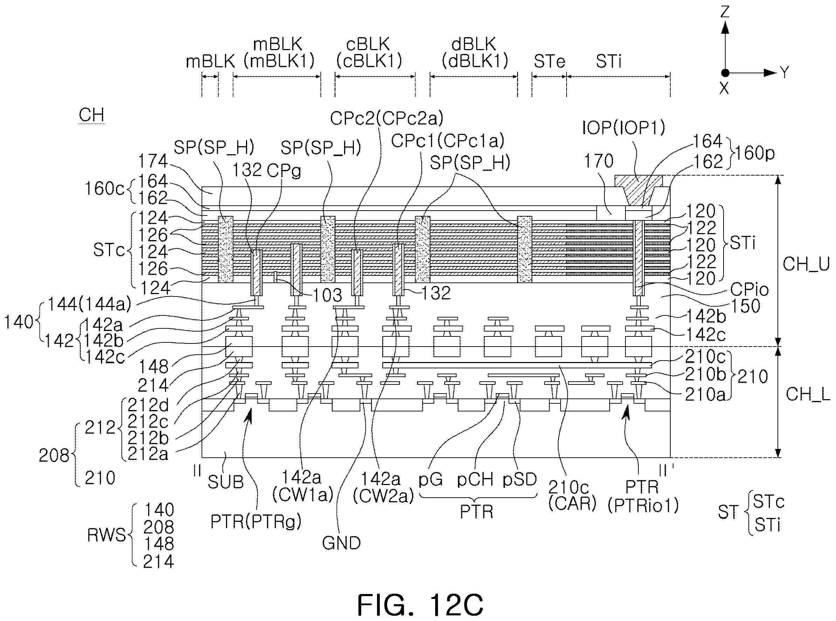

In a modified example, referring to FIG. 12C, the capacitor routing interconnections (CAR in FIG. 6B) may include the third horizontal portion 210c of the horizontal portions 210a, 210b, and 210c of the lower interconnection structure 208 among the routing interconnection structure RWS.

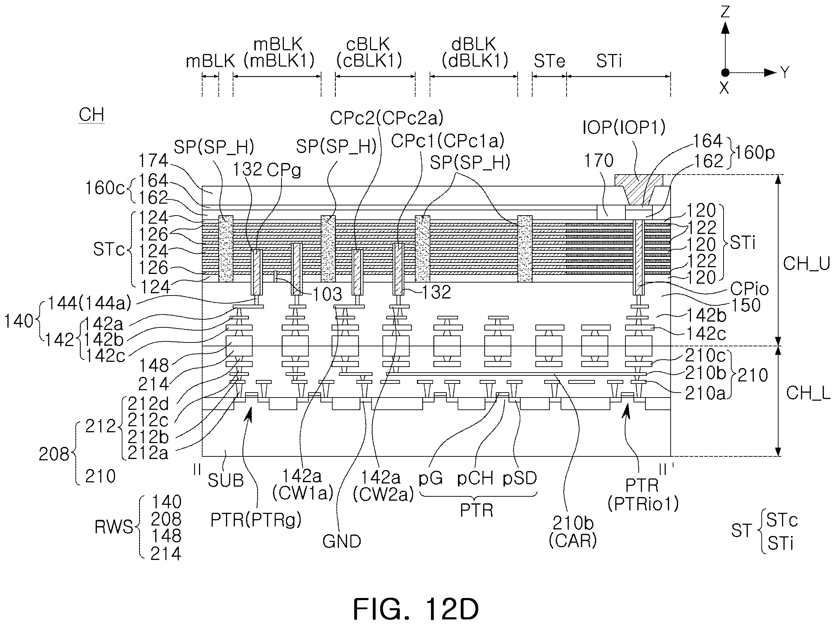

In a modified example, referring to FIG. 12D, the capacitor routing interconnections (CAR in FIG. 6B) may include the second horizontal portion 210b of the horizontal portions 210a, 210b, and 210c of the lower interconnection structure 208 among the routing interconnection structure RWS.

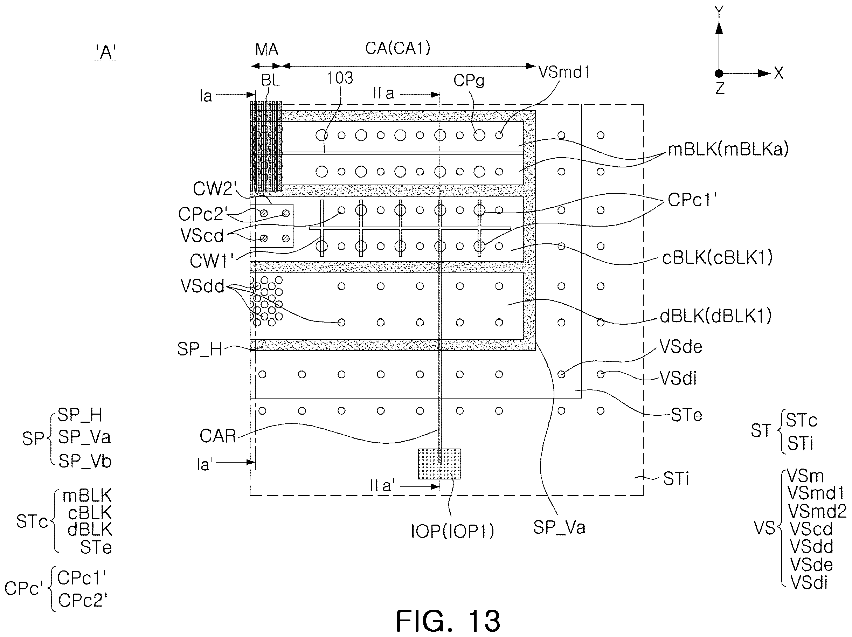

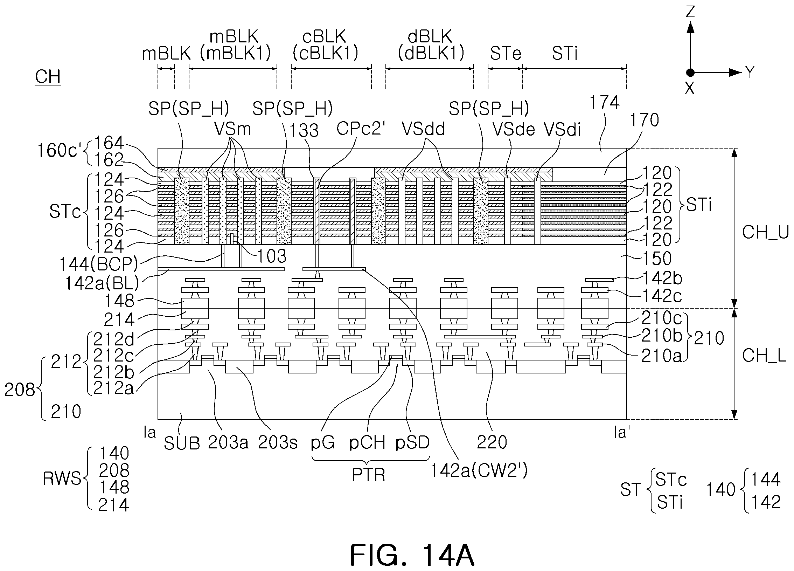

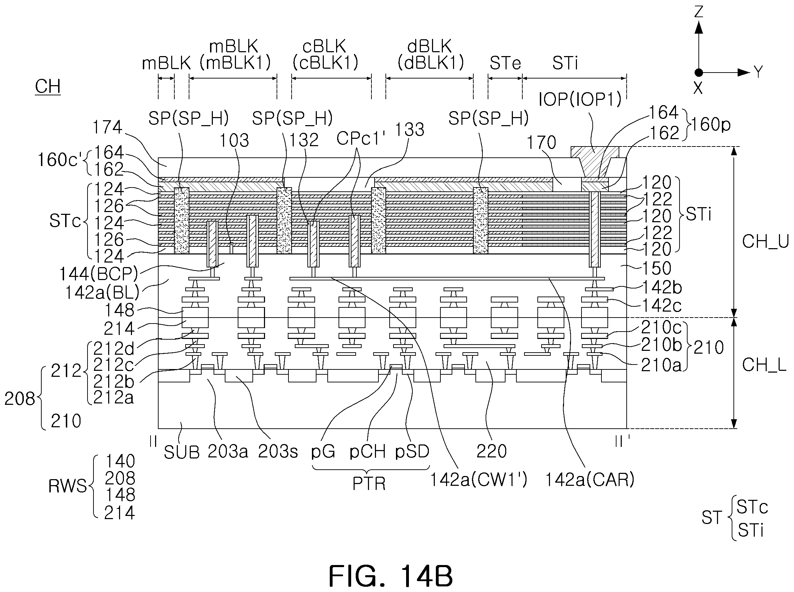

In the description below, a modified example of the capacitor block cBLK in a semiconductor device according to an example embodiment will be described with reference to FIGS. 13, 14A, and 14B. FIG. 13 is the diagram illustrating a modified element in the diagram corresponding to FIG. 4A, and FIG. 14A illustrates a region taken along the line Ia-Ia' in FIG. 13 and is a cross-sectional diagram illustrating modified elements in the cross-sectional structure corresponding to FIG. 6A, and FIG. 14B illustrates a region taken along the line IIa-IIa' in FIG. 13 and is a cross-sectional diagram illustrating modified elements in the cross-sectional structure corresponding to FIG. 6B.

Referring to FIGS. 13, 14A, and 14B, in the capacitor block cBLK, capacitor contact plugs CPc1' electrically connected to the conductive layers 126 may be electrically connected to each other by first capacitor electrode interconnection CW1'. Accordingly, in the capacitor block cBLK, the conductive layers 126 may be a first capacitor electrode.

In the capacitor block cBLK, the support structures VScd penetrating through the conductive stack region STc in the capacitor block cBLK may be replaced with electrode plugs CPc2' and dielectric layers 133 covering the side surfaces and upper surfaces of the electrode plugs CPc2'. The electrode plugs CPc2' may be electrically connected by the second capacitor electrode interconnection CW2'. Accordingly, the electrode plugs CPc2' may be a second capacitor electrode.

Accordingly, the capacitor of the capacitor block cBLK (CAP in FIG. 1D) may include the first capacitor electrode including the conductive layers 126, the second capacitor electrode including the electrode plugs CPc2', and the dielectric layers 133 between the first capacitor electrode and the second capacitor electrode.

The upper plate pattern 160c described above may cover the capacitor CAP of the capacitor block cBLK, but in example embodiments, the upper plate pattern 160c may be modified to an upper plate pattern 160c' not covering the capacitor CAP of the capacitor block cBLK.

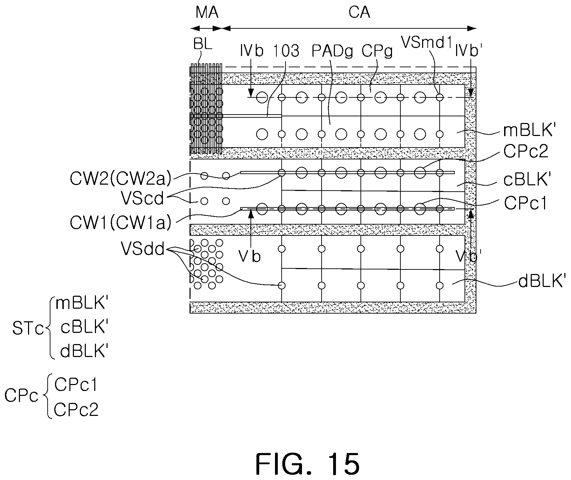

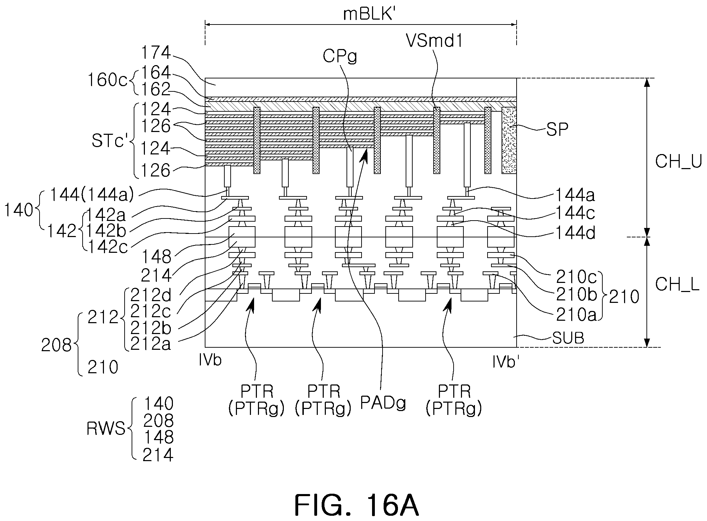

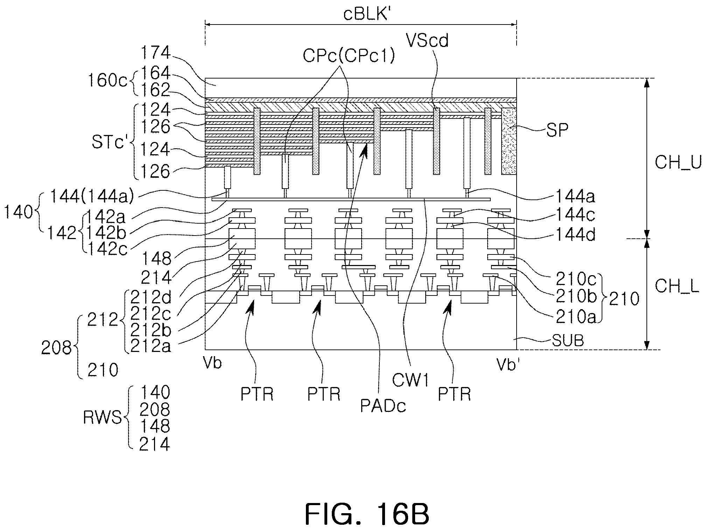

In the description below, a modified example of the memory block mBLK and the capacitor block cBLK in a semiconductor device according to an example embodiment will be described with reference to FIGS. 15, 16A, and 16B. FIG. 15 is a diagram illustrating an element modified from the diagram corresponding to FIG. 4A, FIG. 16A illustrates a region taken along line IVa-IVa' in FIG. 15, and FIG. 16B illustrates a region taken along line Vb-Vb' in FIG. 15.

Referring to FIGS. 15, 16A, and 16B, the conductive stack region STc, in which the gate contact plugs CPg and the capacitor contact plugs CPc described above are disposed, may be modified to a conductive stack region STc' arranged in a staircase shape and including conductive layers 126 having pad regions PADg and PADc connected to the contact plugs CPg and CPc. Accordingly, the memory block mBLK described above may be modified to a memory block mBLK' including conductive layers 126 including gate pad regions PADg arranged in a staircase shape, and the capacitor block cBLK described above may be modified to capacitor block cBLK' including conductive layers 126 including capacitor pad regions PADc arranged in a staircase shape.

The capacitor pad regions PADc may be electrically connected to the capacitor contact plugs CPc, and the gate pad regions PADg may be electrically connected to the gate contact plugs CPg.

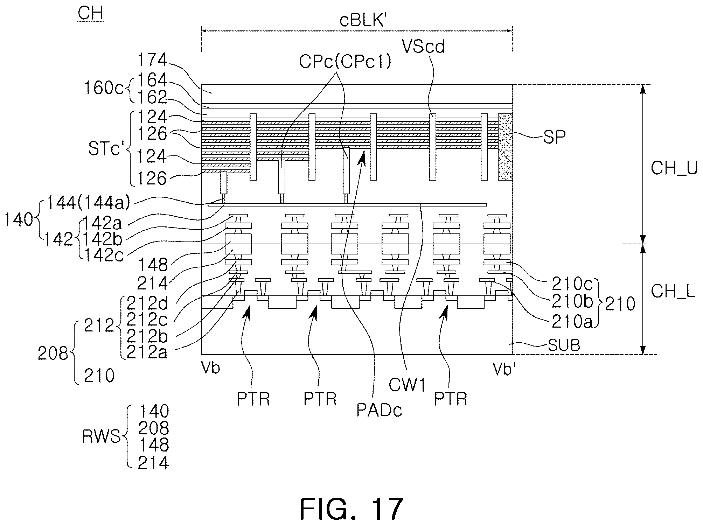

In the description below, a modified example of the capacitor block cBLK in a semiconductor device according to an example embodiment will be described with reference to FIG. 17. FIG. 17 may illustrate a region taken along line Vb-Vb' in FIG. 15.

Referring to FIG. 17, in the example embodiments described above with reference to FIGS. 1A to 16B, the capacitor (CAP in FIGS. 1 and 8D) may use the conductive layers 126 in the capacitor block cBLK as the capacitor electrodes described above (CAP_E1, CAP_E2 in FIG. 8D), but an example embodiment thereof is not limited thereto. For example, to adjust capacity of the capacitor (CAP in FIG. 1 and FIG. 8D), the capacitor block cBLK described above may be modified to a capacitor block cBLK' in which only a portion of the conductive layers 126 is used as the capacitor electrodes (CAP_E1 and CAP_E2 in FIG. 8D). For example, among the conductive layers 126 in the capacitor block cBLK', the lower conductive layers disposed in the lower region may be electrode layers used as the capacitor electrodes (CAP_E1 and CAP_E2 in FIG. 8D), and among the conductive layers 126 in the capacitor block cBLK', the upper conductive layers disposed in the upper region may be dummy conductive layers not used as the capacitor electrodes (CAP_E1 and CAP_E2 in FIG. 8D).

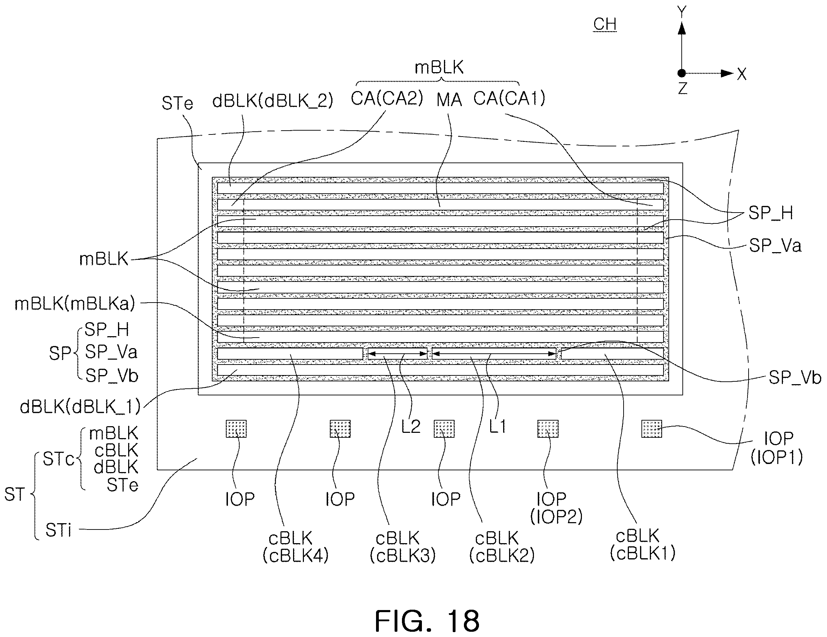

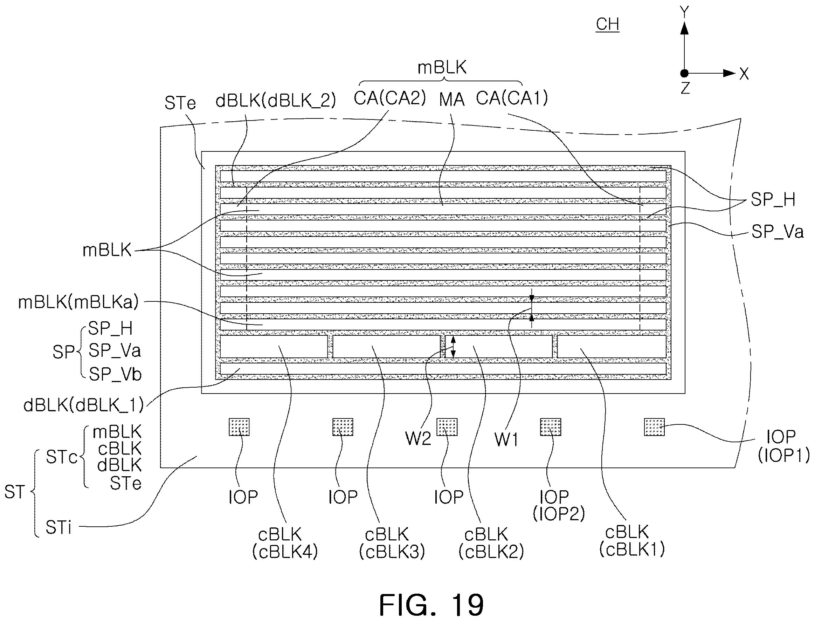

In the description below, modified examples of the capacitor blocks cBLK will be described with reference to FIGS. 18 and 19. FIGS. 18 and 19 are diagrams illustrating a modified example of the capacitor blocks cBLK in the diagram in FIG. 2.

In a modified example, referring to FIG. 18, at least a portion capacitor blocks among the first to fourth capacitor blocks cBLK1, cBLK2, cBLK3, and cBLK4 of the capacitor blocks cBLK may have different lengths in the first direction X. For example, the second capacitor block cBLK2 may have a first length L1, and the third capacitor block cBLK3 may have a second length L2 smaller than the first length L1 in the first direction X.

In a modified example, referring to FIG. 19, in the second direction Y, each of the memory blocks mBLK may have a first width W1, and at least one of the first to fourth capacitor blocks cBLK1, cBLK2, cBLK3, and cBLK4 of the capacitor blocks cBLK may have a second width W2 that is different from the first width W1. The second width W2 may be greater than the first width W1, but an example embodiment thereof is not limited thereto. For example, the second width W2 may be smaller than the first width W1.

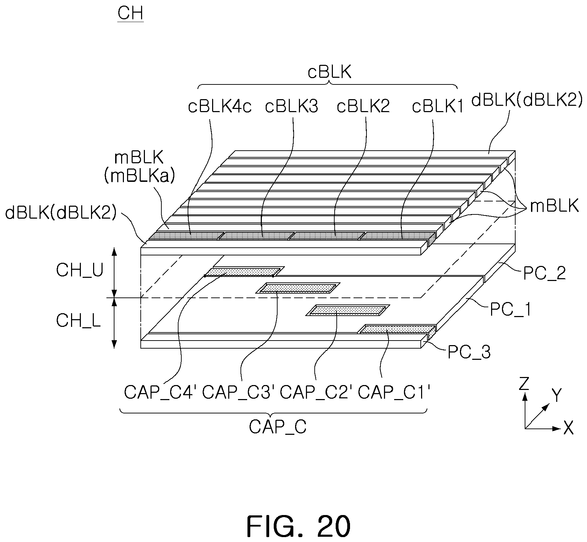

In the description below, modified examples of the capacitor blocks cBLK will be described with reference to FIG. 20. FIG. 20 is a perspective diagram illustrating a modified example of regions in which the fourth lower circuits CAP_C, which may be electrically connected to the capacitors (CAP in FIG. 1D) of the plurality of capacitor blocks cBLK in the perspective diagram in FIG. 3, are disposed.

In a modified example, referring to FIG. 20, a portion of the first capacitor connection circuit CAP_C1', which may be electrically connected to the capacitor of the first capacitor block cBLK1, second capacitor connection circuit CAP _C2', which may be electrically connected to the capacitor of the second capacitor block cBLK2, third capacitor connection circuit CAP _C3', which may be electrically connected to the capacitor of the third capacitor block cBLK3, and a fourth capacitor connection circuit CAP_C4' which may be electrically connected to the capacitor of the fourth capacitor block cBLK4 may vertically overlap a portion of the capacitor blocks cBLK, and another portion may not vertically overlap the capacitor blocks cBLK.

For example, the first capacitor connection circuit CAP_C1', which may be electrically connected to the capacitor of the first capacitor block cBLK1 (CAP in FIG. 1D), may vertically overlap the first capacitor block cBLK1, and the second to fourth capacitor connection circuits CAP _C2', CAP_C3', and CAP_C4' may not vertically overlap the capacitor blocks cBLK.

At least one of the second and third capacitor connection circuits CAP_C2' and CAP_C3' may be adjacent to or surrounded by the first lower circuit PC_1.

The fourth capacitor connection circuit CAP_4' may be adjacent to the second lower circuit PC_2 or may be surrounded by the second lower circuit PC_2.

The example embodiments described above with reference to FIGS. 2 to 20 are described with a focus on one memory mat MAT among the plurality of memory mats (MAT in FIG. 1B) of the semiconductor device CH described with reference to FIG. 1B above. However, an example embodiment thereof is not limited thereto. In the description below, the first mat and second mat adjacent to each other in the first direction will be mainly described.

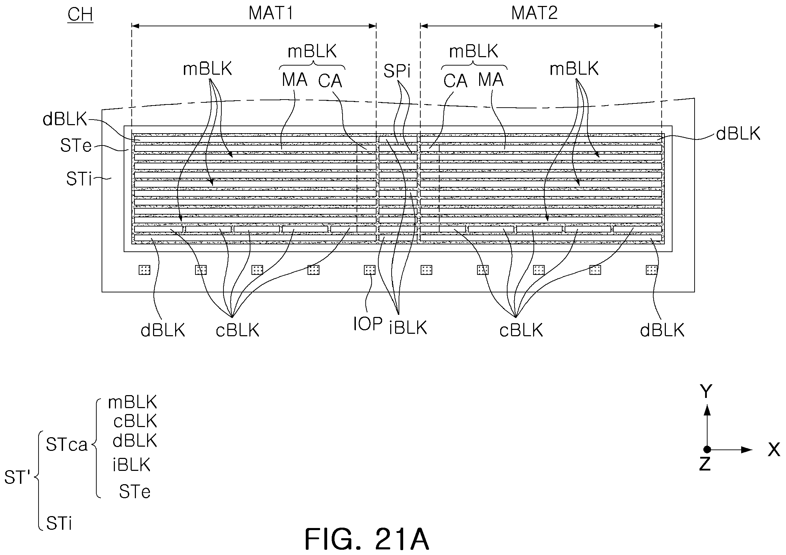

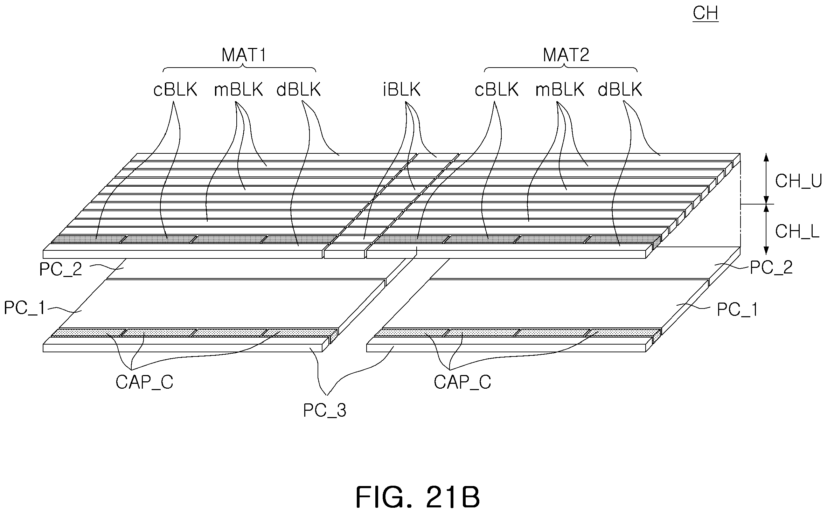

First, among the plurality of memory mats (MAT in FIG. 1B) described with reference to FIG. 1B, example embodiment of a semiconductor device CH including first mat MAT1 and second mat MAT2 adjacent to each other in the first direction will be described with reference to FIGS. 21A and 21B. In FIGS. 21A and 21B, FIG. 21A is a diagram illustrating an example embodiment of a semiconductor device CH, and FIG. 21B is a perspective diagram illustrating an example embodiment of a semiconductor device CH.

Referring to FIGS. 21A and 21B, the semiconductor device CH may include first mat MAT1 and second mat MAT2 adjacent to each other in the first direction X. Each of the first and second mats MAT1 and MAT2 may include the first chip structure CH_L and the second chip structure CH_U described with reference to FIGS. 2 to 20.

As described with reference to FIGS. 2 to 20, the second chip structure CH_U may include a plurality of blocks cBLK, mBLK, and dBLK described with reference to FIGS. 2 to 20.

The second chip structure CH_U may further include intermediate blocks iBLK disposed between the first and second mats MAT1 and MAT2.

The separation structure SP described with reference to FIGS. 2 to 20 may be modified to a separation structure SPi defining the plurality of blocks cBLK, mBLK, and dBLK within the first and second mats MAT1 and MAT2, extending to a region between the first and second mats MAT1 and MAT2 and defining the intermediate blocks iBLK. The conductive stack region STc described with reference to FIGS. 2 to 20 may be modified to a conductive stack region STca including the plurality of blocks cBLK, mBLK, and dBLK within the first and second mats MAT1 and MAT2, the intermediate blocks iBLK, and an edge block STe having a quadrangular ring shape surrounding the external side surface of the separation structure SPi. Each of the plurality of blocks cBLK, mBLK, dBLK, the intermediate blocks iBLK, and the edge block STe may include the insulating layers 124 and the conductive layers 126 described with reference to FIGS. 2 to 20. The insulating stack region STi described above may have a shape to surround the external side of the conductive stack region STca. Accordingly, the semiconductor device CH may include a stack structure ST' including the conductive stack region STca and the insulating stack region STi.

The plurality of lower circuits PC_1, PC_2, PC_3, and CAP_C described above may be disposed below the first and second mats MAT1 and MAT2, respectively.

In an example embodiment, the intermediate blocks iBLK may be dummy blocks, but an example embodiment thereof is not limited thereto. At least a portion of the intermediate blocks iBLK may be configured as a capacitor block cBLK.

Accordingly, when at least a portion of the intermediate blocks iBLK is a capacitor block, the capacitor blocks (cBLK in FIG. 1D) may include capacitor blocks cBLK included in the first and second mats MAT1 and MAT2 and capacitor blocks iBLK disposed between the first and second mats MAT1 and MAT2.

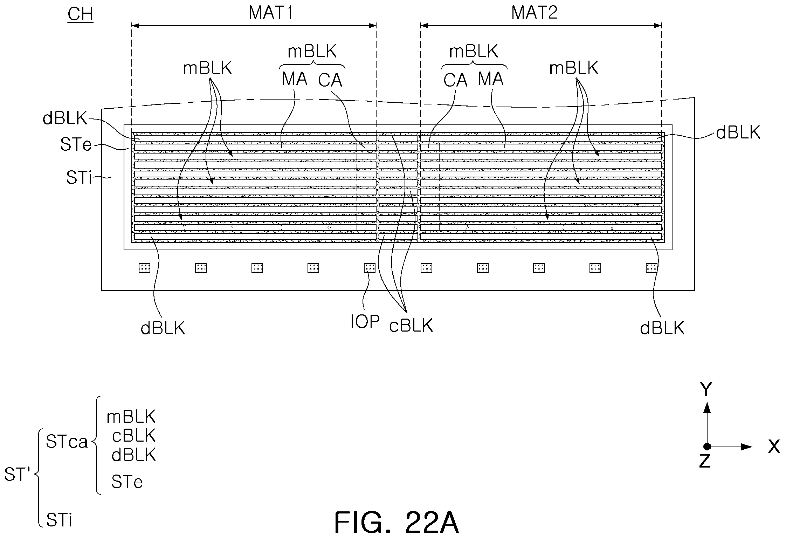

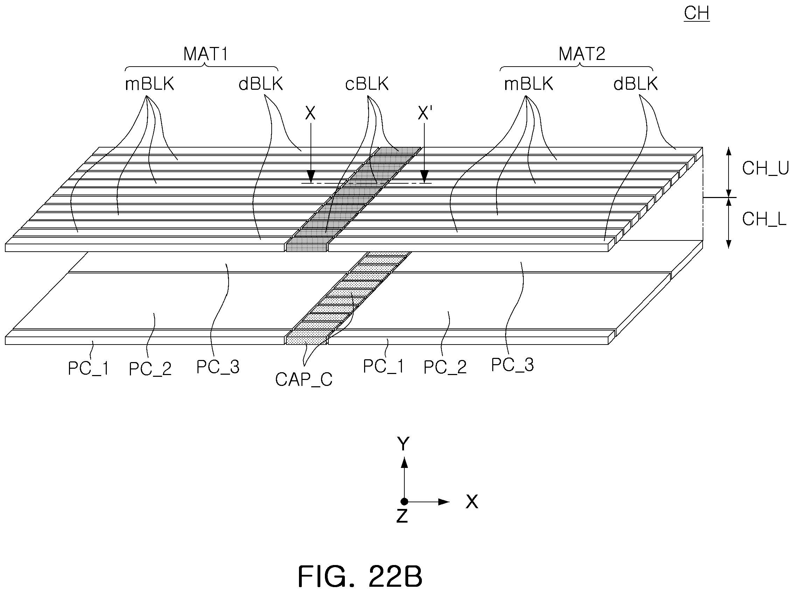

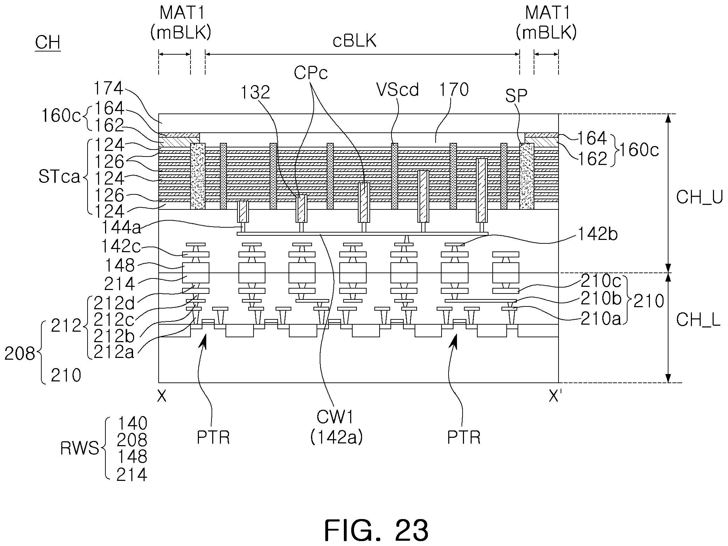

In the description below, an example embodiment in which the intermediate blocks (iBLK in FIGS. 21A and 21B) are replaced with capacitor blocks cBLK including the capacitors (CAP in FIG. 1D) will be described with reference to FIGS. 22A, 22B, and 23. FIG. 22A is a diagram illustrating an example embodiment of a semiconductor device CH, FIG. 22B is a perspective diagram illustrating an example embodiment of a semiconductor device CH, and FIG. 23 is a cross-sectional diagram illustrating region taken along line X-X' in FIG. 22B.

Referring to FIGS. 22A, 22B, and 23, at least one of the intermediate blocks (iBLK in FIGS. 21A and 21B) described with reference to FIGS. 21A and 21B may be replaced with capacitor blocks cBLK. In FIGS. 22A, 22B, and 23, the first and second mats MAT1 and MAT2 may not include the capacitor blocks cBLK, but as described in the aforementioned example embodiment, in example embodiments, the first and second mats MAT1 and MAT2 may include the capacitor blocks cBLK.

The capacitor blocks cBLK may be disposed between the blocks mBLK and dBLK of the first mat MAT1, and the blocks mBLK and dBLK of the second mat MAT2.

Each of the capacitor blocks cBLK may have a bar shape extending in the first direction X. The capacitor blocks cBLK may be spaced apart from each other in the second direction Y by the separation structure SPi.

Each of the capacitor blocks cBLK disposed between the first and second mats MAT1 and MAT2 may include the insulating layers 124 and the conductive layers 126 as described with reference to FIGS. 2 to 20.

The conductive layers 126, which may form capacitor electrodes in the capacitor blocks cBLK, may be electrically connected to the capacitor contact plugs CPc as described above. The capacitor contact plugs CPc may be electrically connected by capacitor electrode interconnections CW.

Each of the first and second mats MAT1 and MAT2 may include the upper plate pattern 160c described above. The upper plate pattern 160c of the first mat MAT1 and the plate pattern 160c of the second mat MAT2 may be spaced apart from each other in the first direction X.

As described above, the first chip structure CH_L may include the fourth lower circuits CAP_C, which may be electrically connected to the capacitors (CAP in FIG. 1D) of the plurality of capacitor blocks cBLK. At least a portion of the fourth lower circuits CAP_C may vertically overlap at least a portion of the plurality of capacitor blocks cBLK.

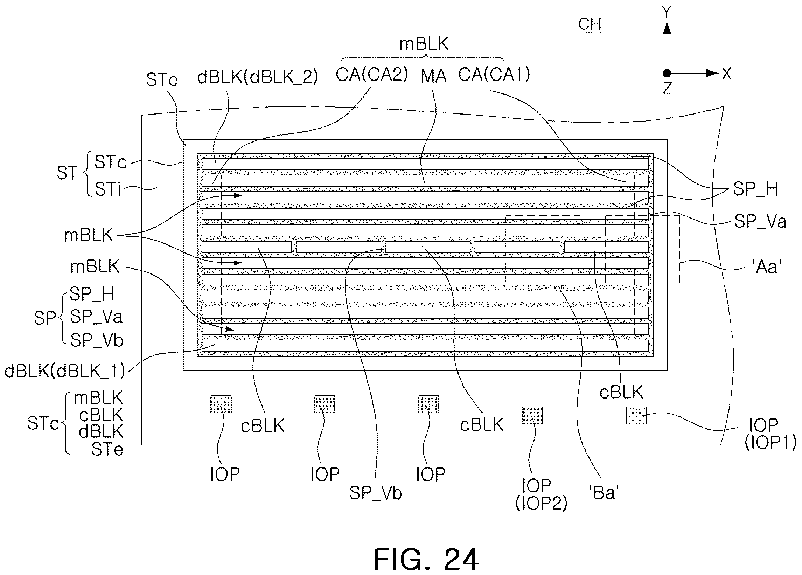

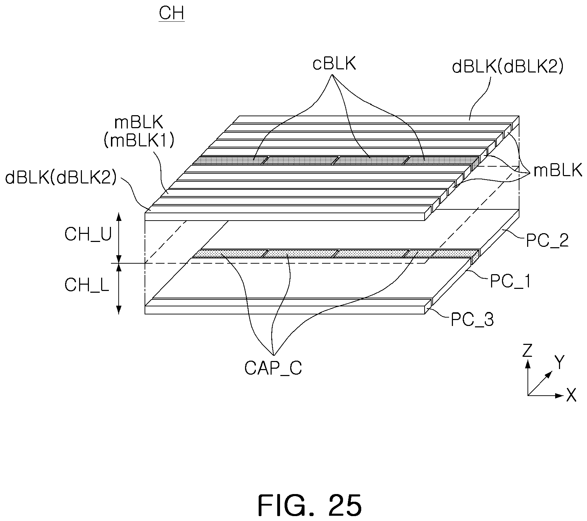

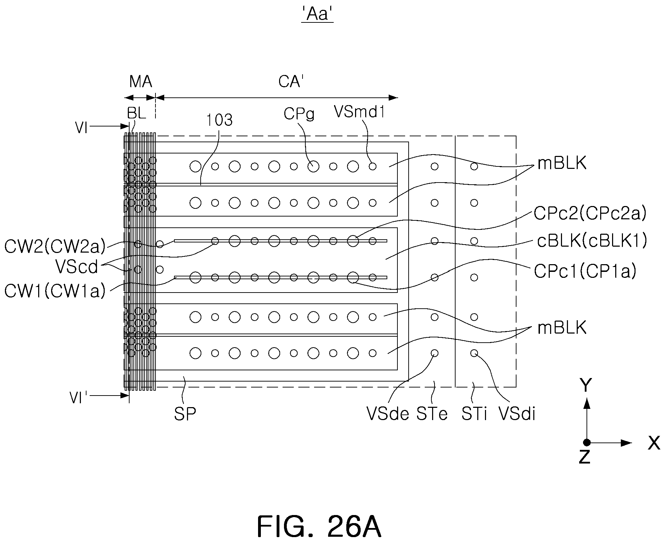

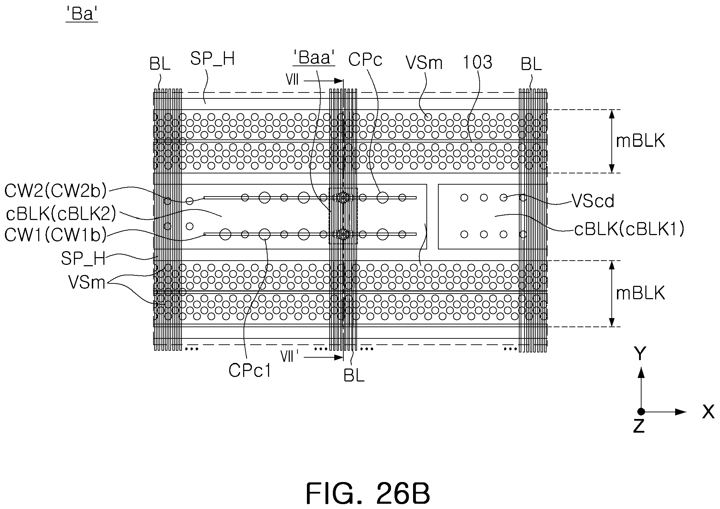

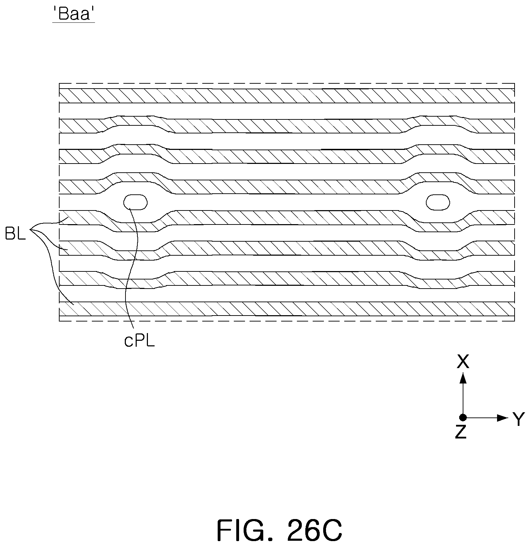

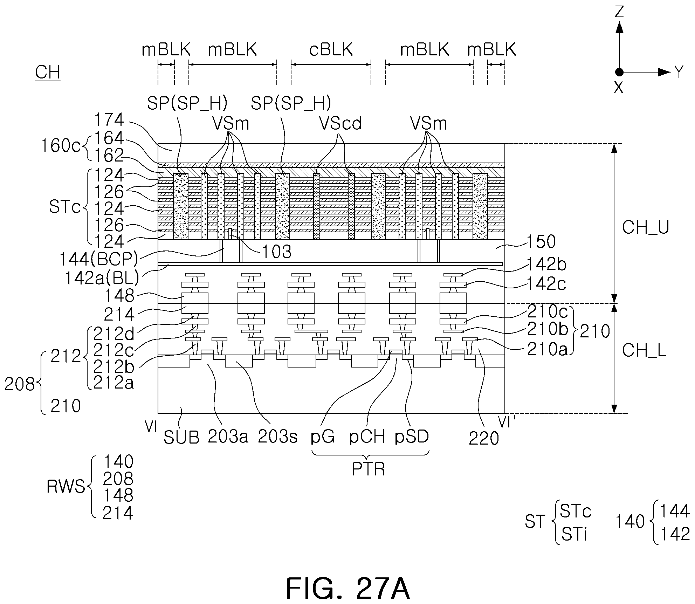

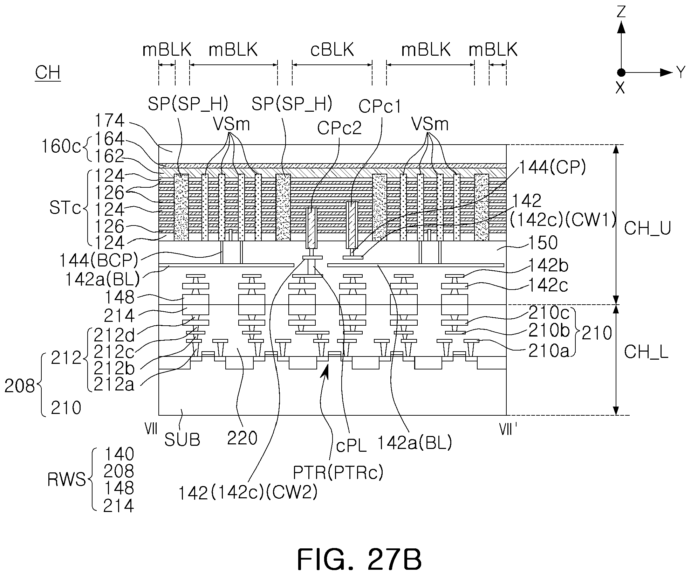

In the description below, a modified example of a semiconductor device according to an example embodiment will be described with reference to FIGS. 24, 25, 26A, 26B, 26C, 27A and 27B. FIG. 24 is a diagram illustrating a modified example of a semiconductor device CH, FIG. 25 is a perspective diagram illustrating a modified example of a semiconductor device CH, FIG. 26A is an enlarged diagram illustrating region "Aa" in FIG. 24, FIG. 26C is an enlarged diagram illustrating region "Ba" in FIG. 24, FIG. 26B is an enlarged diagram illustrating region "Baa" in FIG. 26B. 27A is a cross-sectional diagram illustrating region taken along the line VI-VI' in FIG. 26A, and FIG. 27B is a cross-sectional diagram illustrating region taken along line VII-VII' in FIG. 26B.

Referring to FIGS. 24 to 27B, the capacitor blocks cBLK described with reference to FIGS. 2 to 20 may be disposed between the dummy block dBLK and the first memory block mBLKa, which are adjacent to each other in the second direction Y, but an example embodiment thereof is not limited thereto. For example, as illustrated in FIGS. 24 to 27B, the capacitor blocks (cBLK in FIG. 1D) may be disposed between plurality of memory blocks mBLK and plurality of memory blocks mBLK among the memory blocks mBLK parallel to each other and spaced apart from each other in the second direction Y.

As described above, in the first chip structure CH_L, at least a portion of the fourth lower circuits CAP_C, which may be electrically connected to the capacitors (CAP in FIG. 1D) of the plurality of capacitor blocks cBLK, may vertically overlap at least a portion of the plurality of capacitor blocks cBLK, and may be disposed between the first and second lower circuits PC_1 and PC_2.

The upper plate pattern 160c described above may cover an upper portion of the stack region STc in the memory blocks mBLK and may cover an upper portion of the stack region STc of the capacitor blocks cBLK.

The bit lines BL described above may intersect the plurality of memory blocks mBLK in the second direction Y. Accordingly, the bit lines BL may intersect the plurality of memory blocks mBLK and the capacitor blocks cBLK disposed between the plurality of memory blocks mBLK.

Each of the capacitor blocks cBLK may include the insulating layers 124 and the conductive layers 126 as described with reference to FIGS. 2 to 20. The conductive layers 126, which may form capacitor electrodes in the capacitor blocks cBLK, may be electrically connected to the capacitor contact plugs CPc as described above. The capacitor contact plugs CPc may be electrically connected by capacitor electrode interconnections CW1 and CW2.

The upper interconnection structure 140 may further include an upper horizontal portion 142c which may be disposed on a level higher than a level of the first horizontal portion 142a which may be included in the bit lines BL. The upper horizontal portion 142c may be included in the capacitor electrode interconnections CW1 and CW2.

The vertical portions 144 of the upper interconnection structure 140 may further include a first upper vertical portion forming first contact plugs CP electrically connecting the capacitor electrode interconnections CW1 and CW2 to the capacitor contact plugs CPc between the capacitor electrode interconnections CW1 and CW2 and the capacitor contact plugs CPc, and a second upper vertical a portion passing between the bit lines BL below the capacitor electrode interconnections CW1 and CW2 and forming second contact plugs cPL electrically connected to the interconnections including the second horizontal portion 142b.

The bit lines BL may be parallel to each other at a predetermined distance in the memory blocks mBLK, and the distance between the bit lines BL may be increased such that the second contact plugs cPL may pass between the bit lines BL in regions in which the second contact plugs cPL are disposed. Accordingly, among the bit lines BL, the bit lines BL adj acent to the second contact plugs cPL may have a line shape extending in the second direction Y on the memory blocks mBLK and may have a curved shape on the capacitor blocks cBLK.

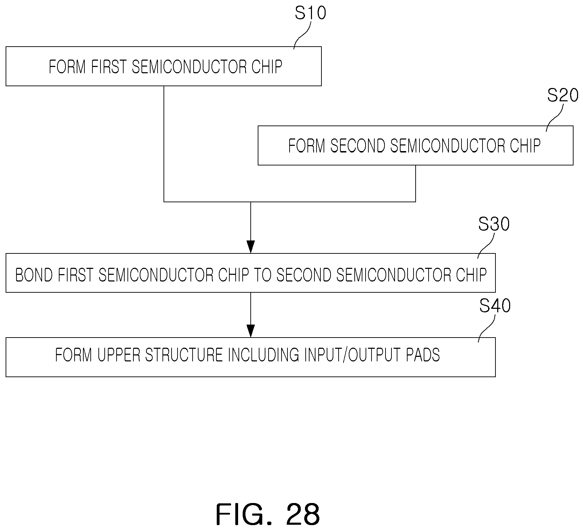

In the description below, an example embodiment of the method of forming the semiconductor device CH described above will be described with reference to FIG. 28.

Referring to FIG. 28 along with FIGS. 1 to 27B, the first semiconductor chip may be formed (S10). The first semiconductor chip may be the first chip structure CH_L in the example embodiments described with reference to FIGS. 1 to 27B. A second semiconductor chip may be formed (S20). The second semiconductor chip may include a portion of the second chip structure CH_U in the example embodiments described with reference to FIGS. 1 to 27B. For example, the second semiconductor chip may include the stack structure ST including the insulating stack region STi and the conductive stack region STc including the plurality of blocks mBLK, dBLK, and cBLK, the vertical structures VS, the upper bonding pads 148, and the upper interconnection structure 140 among the second chip structure CH_U in the example embodiments described with reference to FIGS. 1 to 27B.

The first semiconductor chip and the second semiconductor chip may be bonded to each other (S30). The bonding the first semiconductor chip to the second semiconductor chip may include performing an inter-metal bonding process on the lower bonding pads (214 in FIG. 6A) of the first semiconductor chip and the upper bonding pads (148 in FIG. 6A) of the second semiconductor chip.

An upper structure including input/output pads IOP may be formed (S40). The upper structure may further include the upper plate pattern 160c.

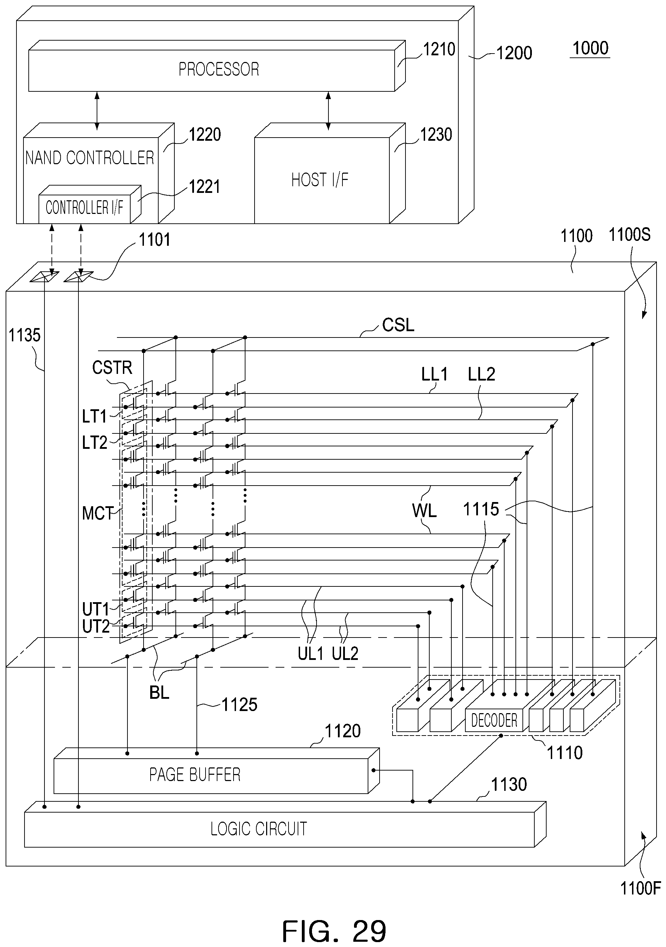

An electronic system including a semiconductor device according to an example embodiment will be described with reference to FIG. 29. FIG. 29 is a diagram illustrating an electronic system including a semiconductor device according to an example embodiment.

Referring to FIG. 29, an electronic system 1000 according to an example embodiment may include a semiconductor device 1100 and a controller 1200 electrically connected to the semiconductor device 1100. The electronic system 1000 may be configured as a storage device including one or a plurality of semiconductor devices 1100 or an electronic device including a storage device. For example, the electronic system 1000 may be configured as a solid state drive device (SSD device), a universal serial bus (USB), a computing system, a medical device, or a communication device including one or the plurality of semiconductor devices 1100.

The semiconductor device 1100 may be configured as a non-volatile memory device according to one of the example embodiments described with reference to FIGS. 1 to 28. The semiconductor device 1100 may include a first structure 1100F and a second structure 1 1005 on the first structure 1100F.

In an example embodiment, the first structure 1100F may be the first chip structure CH_L of any of the example embodiments described above, and second structure 1100S may be the second chip structure CH_U of one of the example embodiments described above.

The first chip structure 1100F may be configured as a peripheral circuit structure including a decoder circuit 1110, a page buffer 1120, and a logic circuit 1130. In an example embodiment, the peripheral circuit 14 of the first chip structure 1100F of one of the example embodiments described above may be configured as a peripheral circuit structure including a decoder circuit 1110, a page buffer 1120, and a logic circuit 1130.

The second chip structure 1100S may be configured as a memory vertical structure including a bit line BL, a common source line CSL, word lines WL, first and second gate upper lines UL1 and UL2, first and second gate lower lines LL1 and LL2, and memory cell strings CSTR between the bit line BL and the common source line CSL.

In an example embodiment, at least a portion of the upper plate pattern 160c described above may be included in the common source line CSL.

In an example embodiment, first and second gate lower lines LL1 and LL2, word lines WL, and first and second gate upper lines UL1 and UL2 may be the conductive layers 126 of the memory blocks mBLK of any one of the example embodiments described above. Accordingly, the conductive layers 126 of the memory blocks mBLK may include first and second gate lower lines LL1 and LL2, word lines WL, and first and second gate upper lines UL1 and UL2. At least a portion of the first and second gate lower lines LL1 and LL2, and the first and second gate upper lines UL1 and UL2 may be selected gate electrodes.

In the second chip structure 1100S, each of the memory cell string CSTR may include lower transistors LT1 and LT2 adjacent to the common source line CSL, upper transistors UT1 and UT2 adjacent to the bit line BL, and the plurality of memory cell transistors MCT disposed between the lower transistors LT1 and LT2 and the upper transistors UT1 and UT2. The number of lower transistors LT1 and LT2 and the number of upper transistors UT1 and UT2 may be modified in various manners in example embodiments. The plurality of memory cell transistors MCT may include data storage regions which may store data DATA.

In example embodiments, the upper transistors UT1 and UT2 may include a string select transistor, and the lower transistors LT1 and LT2 may include a ground select transistor. The gate lower lines LL1 and LL2 may be the gate electrodes of the lower transistors LT1 and LT2, respectively. The word lines WL may be the gate electrodes of the memory cell transistors MCT, and the gate upper lines UL1 and UL2 may be the gate electrodes of the upper transistors UT1 and UT2, respectively.

In example embodiments, the lower transistors LT1 and LT2 may include a lower erase control transistor LT1 and a ground selection transistor LT2 connected in series. The upper transistors UT1 and UT2 may include a string selection transistor UT1 and an upper erase control transistor UT2 connected in series. At least one of the lower erase control transistor LT1 and the upper erase control transistor UT1 may be used in an erase operation to erase data stored in the memory cell transistors MCT using the gate induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first interconnections 1115 extending from the first chip structure 1100F to the second chip structure 1100S. The bit lines BL may be electrically connected to the page buffer 1120 through the second interconnections 1125 extending from the first structure 1100F to the second structure 1100S.

In the first chip structure 1100F, the decoder circuit 1110 and the page buffer 1120 may perform a control operation on at least one selected memory cell transistor among the plurality of memory cell transistors MCT. The decoder circuit 1110 and page buffer 1120 may be controlled by the logic circuit 1130. The semiconductor device 1000 may communicate with the controller 1200 through input/output pads 1101 electrically connected to the logic circuit 1130. The input/output pads 1101 may be electrically connected to the logic circuit 1130 through the input/output interconnection 1135 extending from the first chip structure 1100F to the second chip structure 1100S. The input/output pads 1101 may be the input/output pads IOP described above.

The controller 1200 may include a processor 1210, a NAND controller 1220, and a host interface 1230. In example embodiments, the electronic system 1000 may include a plurality of semiconductor devices 1100, and in this case, the controller 1200 may control the plurality of semiconductor devices 1100.

The processor 1210 may control overall operation of the electronic system 1000, including the controller 1200. The processor 1210 may operate according to predetermined firmware and may access the semiconductor device 1100 by controlling the NAND controller 1220. The NAND controller 1220 may include a NAND interface 1221 processing communication with the semiconductor device 1100. Control commands for controlling the semiconductor device 1100, data to be written to the memory cell transistors MCT of the semiconductor device 1100, and data to be read from the memory cell transistors MCT of the semiconductor device 1100 may be transmitted through the NAND interface 1221. The host interface 1230 may provide a communication function between the electronic system 1000 and an external host. When receiving a control command from an external host through the host interface 1230, the processor 1210 may control the semiconductor device 1100 in response to the control command.

According to the aforementioned example embodiments, a semiconductor device including a capacitor block disposed at the same level as a level of the memory blocks and a data storage system including the same may be provided. Since the capacitor block may form capacitor electrodes using conductive layers disposed at the same level as a level of the conductive layers in the memory block, a high-capacity capacitor may be provided. Accordingly, in a plan view, an area occupied by the high-capacity capacitor may be reduced, thereby improving integration density of the semiconductor device.

Also, since the capacitor in the capacitor block and peripheral circuit may be arranged to overlap vertically, the signal path electrically connecting the capacitor to peripheral circuit may be reduced. Accordingly, RC(Resistance-Capacitance) delay may be reduced, such that performance of the semiconductor device may be improved.

Also, among the plurality of capacitor blocks, the first capacitor of the first capacitor block may be provided to be electrically connected to the first input/output pad. Accordingly, the first capacitor of the first capacitor block, which is electrically connected to the first input/output pad, may act as a damper when the input/output speed (IO speed) increases.

Also, blocks including a capacitor block, dummy block, and memory blocks may be spaced apart from each other by a separation structure. Accordingly, the distance between the blocks may be reduced, such that integration density of the semiconductor device may be improved.

While the example embodiments have been illustrated and described above, it will be configured as apparent to those skilled in the art that modifications and variations could be made without departing from the scope of the present disclosure as defined by the appended claims.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination of two or more of A, B, and C. Likewise, A and/or B means A, B, or A and B.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

In various example embodiments herein, reference may have been made to various circuit elements, including but not limited to capacitors, resistor, inductors, switches, amplifiers, comparators, filters, and transistors. Various different types of digital, analog, active and/or passive components are available for use in implementing the example embodiments. For example, as discussed above, pseudo-resistors can be substituted for passive resistors. Additionally various different transistor types can be used depending on the implementation, whether positive or negative logic is used, manufacturing processes employed, or the like. Furthermore, unless specifically stated otherwise herein, there are many available types of filters, comparators, switches, and the like that can be used to implement the example embodiments.

Embodiments are set out in the following clauses:
Clause 1. A semiconductor device, comprising:
   a first chip structure; and
   a second chip structure vertically overlapping the first chip structure,
   wherein the first chip structure includes peripheral circuits,
   wherein the second chip structure includes:
      a stack structure;
      a separation structure penetrating through the stack structure;
      a plurality of contact plugs; and
      input/output pads,
   wherein the stack structure includes a plurality of blocks spaced apart from each other,
   wherein each of the plurality of blocks includes insulating layers and conductive layers alternately stacked in a vertical direction,
   wherein the plurality of blocks include a plurality of memory blocks and a capacitor block,
   wherein the first and second chip structures further include a routing interconnection structure between the peripheral circuits and the stack structure,
   wherein the plurality of contact plugs include a first input/output contact plug penetrating through the stack structure, and the first input/output contact plug is electrically connected to a first input/output pad of the input/output pads,
   wherein the capacitor block includes a first capacitor electrode and second capacitor electrode, the first capacitor electrode including a plurality of first conductive layers among the conductive layers, and the second capacitor electrode including a plurality of second conductive layers among the conductive layers, and
   wherein the first capacitor electrode is electrically connected to the first input/output pad through the first input/output contact plug and the routing interconnection structure.
Clause 2. The semiconductor device of clause 1, wherein the second capacitor electrode is grounded to a ground region of the first chip structure through the routing interconnection structure.
Clause 3. The semiconductor device of clause 1 or clause 2,
   wherein the routing interconnection structure of the first chip structure includes a lower interconnection structure, the lower interconnection structure including lower vertical portions disposed on different levels and lower horizontal portions disposed on different levels,
   wherein the routing interconnection structure of the second chip structure includes an upper interconnection structure, the upper interconnection structure including upper vertical portions disposed on different levels and upper horizontal portions disposed on different levels, and
   wherein at least one of the lower and upper horizontal portions of the routing interconnection structure is included in a capacitor routing interconnection electrically connecting the first capacitor electrode to the first input/output pad.
Clause 4. The semiconductor device of clause 3,
   wherein the plurality of contact plugs include,
   first capacitor contact plugs connected to the plurality of first conductive layers included in the first capacitor electrode, and
   second capacitor contact plugs connected to the plurality of second conductive layers included in the second capacitor electrode; and
   wherein the routing interconnection structure of the second chip structure further includes,
   a first capacitor interconnection electrically connecting the first capacitor contact plugs to each other, and
   a second capacitor interconnection electrically connecting the second capacitor contact plugs to each other.
Clause 5. The semiconductor device of clause 3 or clause 4,
   wherein the routing interconnection structure of the first chip structure further includes lower bonding pads on the lower interconnection structure, and
   wherein the routing interconnection structure of the second chip structure further includes upper bonding pads, the upper bonding pads disposed below the upper interconnection structure and bonded to the lower bonding pads.
Clause 6. The semiconductor device of any of clauses 3-5,
   wherein the separation structure surrounds a side surface of the capacitor block, and
   wherein a block adjacent to the capacitor block of the plurality of blocks are spaced apart from the capacitor block by the separation structure.
Clause 7. A data storage system, comprising:
   a semiconductor device including input/output pad; and
   a controller electrically connected to the semiconductor device through the input/output pad and controlling the semiconductor device,
   wherein the semiconductor device further includes:
      a peripheral circuit structure;
      a stack structure vertically overlapping the peripheral circuit structure; and
      a separation structure penetrating through the stack structure,
   wherein the stack structure includes a plurality of blocks spaced apart from each other by the separation structure,
   wherein each of the plurality of blocks include insulating layers and conductive layers alternately stacked in a vertical direction,
   wherein the plurality of blocks include first blocks and a plurality of capacitor blocks disposed between first blocks adjacent to each other among the first blocks, and
   wherein the plurality of capacitor blocks are spaced apart from each other by the separation structure.
Clause 8. The data storage system of clause 7,
   wherein each of the plurality of capacitor blocks includes a capacitor,
   wherein the capacitor includes capacitor electrodes including the conductive layers and capacitor dielectric layers including the insulating layers, and
   wherein a side surface of at least one capacitor block of the plurality of capacitor blocks is surrounded by the separation structure.

## Claims

1. A semiconductor device, comprising:
a peripheral circuit structure;
a stack structure vertically overlapping the peripheral circuit structure; and
a separation structure penetrating through the stack structure,
wherein the stack structure includes a plurality of blocks spaced apart from each other by a first portion of the separation structure,
wherein each of the plurality of blocks includes insulating layers and conductive layers alternately stacked in a vertical direction, and
wherein the plurality of blocks include first blocks and a plurality of capacitor blocks disposed between first blocks adjacent to each other among the first blocks.

2. The semiconductor device of claim 1,
wherein the plurality of capacitor blocks are spaced apart from each other by a second portion of the separation structure,
wherein each of the plurality of capacitor blocks includes a capacitor, and
wherein each capacitor includes capacitor electrodes including the conductive layers and capacitor dielectric layers including the insulating layers.

3. The semiconductor device of claim 2,
wherein the peripheral circuit structure includes a first peripheral circuit, and
wherein the first peripheral circuit is included in a circuit by being electrically connected to a first capacitor of a first capacitor block of the plurality of capacitor blocks, and the first peripheral circuit vertically overlaps at least a portion of the first capacitor.

4. The semiconductor device of any preceding claim, wherein a side surface of at least one capacitor block of the plurality of capacitor blocks is surrounded by the separation structure.

5. The semiconductor device of any preceding claim, wherein each of the plurality of blocks has a side surface surrounded by the separation structure.

6. The semiconductor device of any preceding claim,
wherein the first blocks include a plurality of memory blocks and at least one dummy block, and
wherein the conductive layers in the plurality of memory blocks include word lines.

7. The semiconductor device of claim 6,
wherein the plurality of memory blocks include a first memory block adjacent to the plurality of capacitor blocks, and
wherein the plurality of capacitor blocks are disposed between the first memory block and the at least one dummy block.

8. The semiconductor device of claim 6 or claim 7, further comprising:
vertical memory structures penetrating through the plurality of memory blocks;
first vertical support structures penetrating through the plurality of capacitor blocks; and
bit lines electrically connected to the vertical memory structures,
wherein at least a portion of the plurality of capacitor blocks does not overlap the bit lines in the vertical direction.

9. The semiconductor device of any of claims 6-8,
wherein the plurality of memory blocks include a plurality of first memory blocks and a plurality of second memory blocks, and
wherein the plurality of capacitor blocks are disposed between the plurality of first memory blocks and the plurality of second memory blocks.

10. The semiconductor device of claim 9, further comprising:
vertical memory structures penetrating through the memory blocks; and
bit lines electrically connected to the vertical memory structures,
wherein at least one of the plurality of capacitor blocks overlaps the bit lines in the vertical direction.

11. The semiconductor device of any preceding claim,
wherein each of the first blocks extends in a first direction,
wherein the plurality of capacitor blocks are disposed between first blocks adjacent to each other in a second direction perpendicular to the first direction, and
wherein the plurality of capacitor blocks are spaced apart from each other in the second direction.

12. The semiconductor device of any preceding claim, further comprising:
a signal path connecting the peripheral circuit structure to a capacitor block of the plurality of capacitor blocks.

13. The semiconductor device of any preceding claim, further comprising:
a plurality of contact plugs;
input/output pads; and
a routing interconnection structure between the stack structure and a peripheral circuit of the peripheral circuit structure,
wherein the plurality of contact plugs include a first input/output contact plug penetrating through the stack structure, and the first input/output contact plug is electrically connected to a first input/output pad of the input/output pads,
wherein the capacitor block includes a first capacitor electrode and second capacitor electrode, the first capacitor electrode including a plurality of first conductive layers among the conductive layers, and the second capacitor electrode including a plurality of second conductive layers among the conductive layers, and
wherein the first capacitor electrode is electrically connected to the first input/output pad through the first input/output contact plug and the routing interconnection structure.

14. The semiconductor device of claim 13, wherein the second capacitor electrode is grounded to a ground region of the the peripheral circuit structure through the routing interconnection structure.

15. A data storage system, comprising:
a semiconductor device according to any preceding claim, wherein the semiconductor device further includes an input/output pad; and
a controller electrically connected to the semiconductor device through the input/output pad and controlling the semiconductor device.
